(19) Europäisches Patentamt
European Patent Office
Office européen des brevets

(11) EP 3 052 505 B1

(12) EUROPÄISCHE PATENTSCHRIFT

(45) Veröffentlichungstag und Bekanntmachung des Hinweises auf die Patenterteilung:
**23.06.2021 Patentblatt 2021/25**

(21) Anmeldenummer: **14772067.6**

(22) Anmeldetag: **16.09.2014**

(51) Int Cl.:
*C07F 5/02* (2006.01) *C09K 11/02* (2006.01)
*H01L 51/00* (2006.01) *H01L 51/50* (2006.01)
*H05B 33/20* (2006.01)

(86) Internationale Anmeldenummer:
**PCT/EP2014/002493**

(87) Internationale Veröffentlichungsnummer:
**WO 2015/049030 (09.04.2015 Gazette 2015/14)**

(54) **BORENTHALTENDE VERBINDUNGEN**

BORON-CONTAINING COMPOUNDS

COMPOSÉS CONTENANT DU BORE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.10.2013 EP 13004765**

(43) Veröffentlichungstag der Anmeldung:
**10.08.2016 Patentblatt 2016/32**

(73) Patentinhaber: **Merck Patent GmbH**
**64293 Darmstadt (DE)**

(72) Erfinder: **STOESSEL, Philipp**
**60389 Frankfurt am Main (DE)**

(56) Entgegenhaltungen:

| | |
|---|---|
| **WO-A1-02/051850** | **WO-A1-02/051850** |
| **WO-A1-02/051850** | **WO-A1-2010/011426** |
| **WO-A1-2010/126233** | **WO-A1-2013/083216** |
| **WO-A1-2013/083216** | **US-B1- 6 291 695** |

- **DAVID J. H. EMSLIE ET AL: "A Zwitterionic Palladium(II) &eegr; 3 -Boratoxypentadienyl Complex:? Cooperative Activation of Dibenzylideneacetone between Palladium and a Phosphine/Thioether/Borane Ligand", ORGANOMETALLICS, Bd. 25, Nr. 10, 1. Mai 2006 (2006-05-01), Seiten 2412-2414, XP055156506, ISSN: 0276-7333, DOI: 10.1021/om0602052**
- **CHIEN-TIEN CHEN ET AL: "Spirally configured cis-stilbene/fluorene hybrids as ambipolar, fluorescent materials for organic light emitting diode applications", RSC ADVANCES, Bd. 3, Nr. 24, 26. April 2013 (2013-04-26) , Seite 9381, XP055535372, ISSN: 2046-2069, DOI: 10.1039/c3ra41642a**
- **XU XIAOFEI ET AL: "Dimesitylboryl-functionalized fluorene derivatives: Promising luminophors with good electron-transporting ability for deep blue organic light-emitting diodes", DYES AND PIGMENTS, Bd. 101, 10. Oktober 2013 (2013-10-10), Seiten 136-141, XP028772069, ISSN: 0143-7208, DOI: 10.1016/J.DYEPIG.2013.09.042**
- **KSHITIJ PARAB ET AL: "Synthesis and Characterization of Luminescent Polystyrene Derivatives with Sterically Protected Fluorenyl- and Carbazolylborane Moieties", MACROMOLECULES, Bd. 44, Nr. 15, 9. August 2011 (2011-08-09), Seiten 5961-5967, XP055156581, ISSN: 0024-9297, DOI: 10.1021/ma200358s**
- **MARINA CHARLOT ET AL: "Investigation of two-photon absorption behavior in symmetrical acceptor???acceptor derivatives with dimesitylboryl end-groups. Evidence of new engineering routes for TPA/transparency trade-off optimization", PHYSICAL CHEMISTRY CHEMICAL PHYSICS, Bd. 7, Nr. 4, 18. Januar 2005 (2005-01-18) , Seite 600, XP055156535, ISSN: 1463-9076, DOI: 10.1039/b416605a**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 052 505 B1

- TAKESHI MAKINO ET AL: "Concise Synthesis of Diborylxanthenes", SYNTHESIS, Bd. 2008, Nr. 6, 28. Februar 2008 (2008-02-28), Seiten 859-864, XP055156508, ISSN: 0039-7881, DOI: 10.1055/s-2008-1032207
- CHEN Y ET AL: "The synthesis and single and two-photon excited fluorescence of a new quasi-quadrupolar organoborane compound", JOURNAL OF MOLECULAR STRUCTURE, ELSEVIER, AMSTERDAM, NL, Bd. 969, Nr. 1-3, 22. April 2010 (2010-04-22), Seiten 182-186, XP026978890, ISSN: 0022-2860 [gefunden am 2010-02-06]
- ZHANG Y ET AL: "Theoretical study on the electronic structure and optical properties of carbazole--dimesitylborane as bipolar fluorophores for nondoped blue OLEDs", JOURNAL OF MOLECULAR GRAPHICS AND MODELLING, ELSEVIER SCIENCE, NEW YORK, NY, US, Bd. 34, 22. Dezember 2011 (2011-12-22), Seiten 46-56, XP028460420, ISSN: 1093-3263, DOI: 10.1016/J.JMGM.2011.12.007 [gefunden am 2012-01-02]
- DAVID J. H. EMSLIE ET AL: "A Zwitterionic Palladium(II) &eegr; 3 -Boratoxypentadienyl Complex:? Cooperative Activation of Dibenzylideneacetone between Palladium and a Phosphine/Thioether/Borane Ligand", ORGANOMETALLICS, vol. 25, no. 10, 1 May 2006 (2006-05-01), pages 2412-2414, XP055156506, ISSN: 0276-7333, DOI: 10.1021/om0602052
- CHIEN-TIEN CHEN ET AL: "Spirally configured cis-stilbene/fluorene hybrids as ambipolar, fluorescent materials for organic light emitting diode applications", RSC ADVANCES, vol. 3, no. 24, 26 April 2013 (2013-04-26) , page 9381, XP055535372, ISSN: 2046-2069, DOI: 10.1039/c3ra41642a
- XU XIAOFEI ET AL: "Dimesitylboryl-functionalized fluorene derivatives: Promising luminophors with good electron-transporting ability for deep blue organic light-emitting diodes", DYES AND PIGMENTS, vol. 101, 10 October 2013 (2013-10-10), pages 136-141, XP028772069, ISSN: 0143-7208, DOI: 10.1016/J.DYEPIG.2013.09.042

## Beschreibung

Die vorliegende Erfindung betrifft borenthaltende Verbindungen, welche sich für den Einsatz in elektronischen Vorrichtungen eignen. Weiterhin betrifft die vorliegende Erfindung Verfahren zu deren Herstellung und elektronische Vorrichtungen.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische Feldeffekt-Transistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen Vorrichtungen weisen unabhängig von dem jeweiligen Verwendungszweck folgenden allgemeinen Schichtaufbau auf, der für die jeweilige Anwendung angepasst werden kann:

(1) Substrat,
(2) Elektrode, häufig metallisch oder anorganisch, aber auch aus organischen bzw. polymeren, leitfähigen Materialien,
(3) Ladungsinjektionsschicht/en bzw. Zwischenschicht/en, beispielsweise zum Ausgleich von Unebenheiten der Elektrode ("planarisation layer"), häufig aus einem leitfähigen, dotierten Polymer,
(4) Organische Halbleiter,
(5) evtl. weitere Ladungstransport-, Ladungsinjektions- bzw. Ladungsblockierschichten,
(6) Gegenelektrode, Materialien wie unter (2) genannt,
(7) Verkapselung.

Die obige Anordnung stellt den allgemeinen Aufbau einer organischen, elektronischen Vorrichtung dar, wobei verschiedene Schichten zusammengefasst werden können, so dass im einfachsten Fall eine Anordnung aus zwei Elektroden resultiert, zwischen denen sich eine organische Schicht befindet. Die organische Schicht erfüllt in diesem Fall alle Funktionen, einschließlich der Emission von Licht im Fall von OLEDs. Ein derartiges System ist beispielsweise in der WO 90/13148 A1 auf der Basis von Poly-(p-phenylenen) beschrieben.

Elektronische Vorrichtungen mit borenthaltende Verbindungen werden unter anderem in den Druckschriften WO 02/052661 A1 und WO 02/051850 A1 beschrieben. Die darin explizit dargelegten Fluoren- oder Spiro-Verbindungen sind an den 2, 7- Positionen oder an 2', 7'-Positionen der Ringe mit borenthaltenden Resten substituiert.

WO 2002/051850 A1 offenbart Spirobifluorene, die in spezifischer Weise mit Bor-haltigen Gruppen substituiert vorliegen sowie deren Verwendung in organischen Elektrolumineszenzvorrichtungen.

Bekannte elektronische Vorrichtungen weisen ein brauchbares Eigenschaftsprofil auf. Allerdings besteht die dauerhafte Notwendigkeit, die Eigenschaften dieser Vorrichtungen zu verbessern.

Zu diesen Eigenschaften gehört insbesondere die Energieeffizienz, mit der eine elektronische Vorrichtung die vorgegebene Aufgabe löst. Bei organischen Leuchtdioden, die sowohl auf niedermolekularen Verbindungen als auch auf polymeren Materialien basieren können, sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein. Ein weiteres Problem stellt insbesondere die Lebensdauer der elektronischen Vorrichtungen dar.

Aufgabe der vorliegenden Erfindung ist daher die Bereitstellung neuer Verbindungen, welche zu Elektronischen Vorrichtungen mit verbesserten Eigenschaften führen. Insbesondere ist die Aufgabe Lochblockiermaterialien, Elektroneninjektionsmaterialien und/oder Elektronentransportmaterialien bereitzustellen, welche verbesserte Eigenschaften in Bezug auf Effizienz, Betriebsspannung und/oder Lebensdauer zeigen. Weiterhin sollten sich die Verbindungen möglichst einfach verarbeiten lassen, insbesondere eine gute Löslichkeit und Filmbildung zeigen.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Weiterhin sollten die elektronischen Vorrichtungen für viele Zwecke eingesetzt oder angepasst werden können. Insbesondere sollte die Leistungsfähigkeit der elektronischen Vorrichtungen über einen breiten Temperaturbereich erhalten bleiben.

Überraschenderweise wurde gefunden, dass diese sowie weitere nicht explizit genannte Aufgaben, die jedoch aus den hierin einleitend diskutierten Zusammenhängen ohne Weiteres ableitbar oder erschließbar sind, durch Verbindungen mit allen Merkmalen des Patentanspruchs 1 gelöst werden. Zweckmäßige Abwandlungen der erfindungsgemäßen Verbindungen werden in den auf Anspruch 1 rückbezogenen abhängigen Ansprüchen unter Schutz gestellt.

Dabei bedeutet "benachbarte Kohlenstoffatome", dass die Kohlenstoffatome direkt aneinander gebunden sind. Weiterhin bedeutet "benachbarte Reste" in der Definition der Reste, dass diese Reste an dasselbe Kohlenstoffatom oder an benachbarte Kohlenstoffatome gebunden sind. Diese Definitionen gelten entsprechend unter anderem für die Begriffe "benachbarte Gruppen" und "benachbarte Substituenten".

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, 0 und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1 -Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer $C_1$- bis $C_{40}$-A!koxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Triphenyl, Triphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin,

Indolizin und Benzothiadiazol.

Wenn in der Struktur der Formeln gemäß Anspruch 1 Reste $R^2$ gebunden sind, so sind diese Reste $R^2$ bei jedem Auftreten gleich oder verschieden bevorzugt ausgewählt aus der Gruppe bestehend aus H, D, F, Br, I, CN, $Si(R^4)_3$, $B(OR^4)_2$, $C(=O)Ar^1$, einer geradkettigen Alkylgruppe mit 1 bis 10 C-Atomen oder einer geradkettigen Alkoxygruppe mit 1 bis 10 C-Atomen einer Alkenylgruppe mit 2 bis 10 C-Atomen oder einer verzweigten oder cyclischen Alkoxygruppe mit 3 bis 10 C-Atomen oder einer verzweigten oder cyclischen Alkylgruppe mit 3 bis 10 C-Atomen, die jeweils mit einem oder mehreren Resten $R^4$ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste $R^4$ substituiert sein kann; dabei können zwei benachbarte Rest $R^2$ oder $R^2$ mit $R^4$ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, einer geradkettigen Alkoxygruppe mit 1 bis 6 C-Atomen oder einer verzweigten oder cyclischen Alkoxygruppe mit 3 bis 10 C-Atomen, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste $R^4$ substituiert sein kann; dabei können zwei benachbarte Reste $R^2$ oder $R^2$ mit $R^4$ auch miteinander ein mono- oder polycyclisches, aliphatisches oder aromatisches Ringsystem bilden.

Ferner kann vorgesehen sein, dass die Reste $Ar^2$ und $Ar^3$ eine Arylgruppe mit 6 bis 10 Kohlenstoffatomen, vorzugsweise mit 6 Kohlenstoffatomen darstellen, die mit bis zu drei Resten $R^3$ substituiert sein kann; dabei können auch die Reste $Ar^2$ und $Ar^3$ durch eine Einfachbindung oder eine Brücke, ausgewählt aus $B(R^5)$, $C(R^5)_2$, $Si(R^5)_2$, C=O, $C=NR^5$, $C=C(R^5)_2$, 0, S, S=O, $SO_2$, $N(R^5)$, $P(R^5)$ und $P(=O)R^5$, miteinander verknüpft sein. Gemäß einem besonderen Aspekt stellen die Reste $Ar^2$ und $Ar^3$ eine Arylgruppe mit 6 Kohlenstoffatomen, die mit bis zu 3 Alkylresten mit 1 bis 4 Kohlenstoffatomen, vorzugsweise mit Methylresten substituiert sind. Gemäß einem weiteren Aspekt stellen die Reste $Ar^2$ und $Ar^3$ eine Arylgruppe mit 6 Kohlenstoffatomen, die mit bis zu 2 Arylresten mit 6 bis 10 Kohlenstoffatomen, vorzugsweise mit Phenylresten substituiert sind, wobei die Arylreste vorzugsweise über eine Bindung miteinander verbunden sein können.

Anspruch 1 betrifft Verbindung umfassend Strukturen der Formeln (V-5), (V-6), (V-7), (V-8), (V-9) und/oder (V-10)

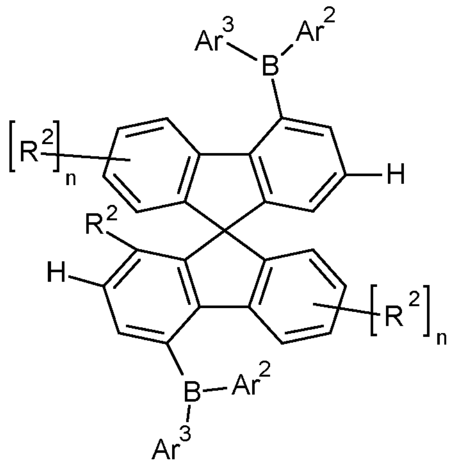

Formel (V-5)

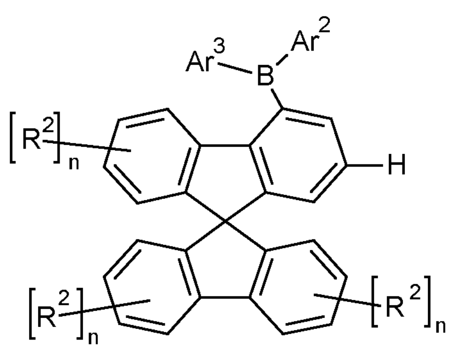

Formel (V-6)

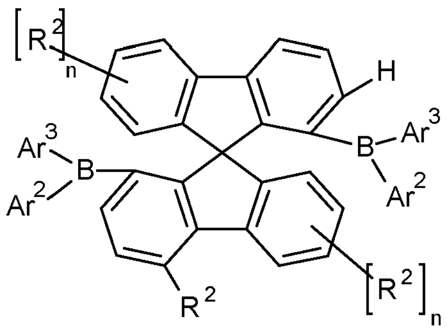

Formel (V-7)

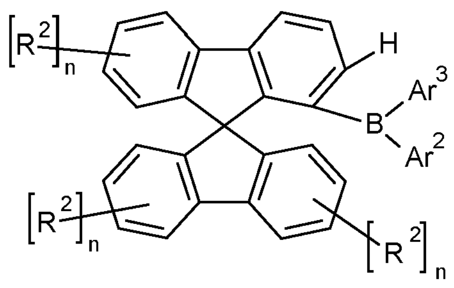

Formel (V-8)

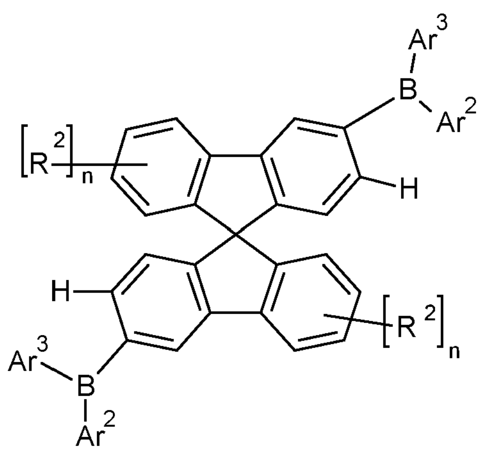

Formel (V-9)

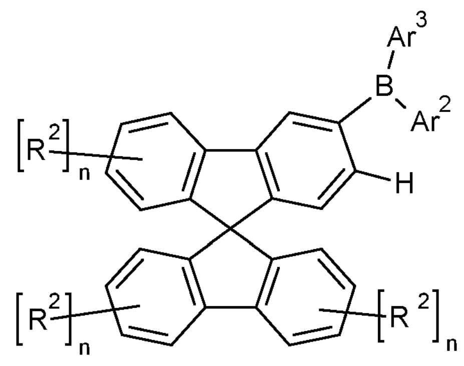

Formel (V-10)

, wobei die verwendeten Symbole die zuvor genannten Bedeutungen haben und n bei jedem Auftreten gleich oder verschieden 0 oder 1 bedeutet.

Insbesondere weisen die erfindungemäßen Verbindungen ein im Vergleich zu Verbindungen des Standes der Technik deutlich höheres T1-Niveau auf, wobei dies für den Bau von grünen und insbesondere von blauen phosphoreszierenden OLEDs von Vorteil ist. Dieser Vorteil ist insbesondere für den Einsatz der Materialien als Triplettmatrixmaterial (TMM), Lochblockiermaterial (HBM) und Elektronentransportmaterial (ETM) wesentlich. In der emittierenden Schicht und den angrenzenden Schichten (EBM / ETM) sollte das T1-Niveau von TMM, EBH, ETM größer oder gleich sein, als die des emittierenden Materials, um ein Quenschen der Emission zu vermeiden.

Molekülorbitale, insbesondere auch das highest occupied molecular orbital (HOMO) und das lowest unoccupied molecular orbital (LUMO), deren Energieniveaus sowie die Energie des niedrigsten Triplettzustands $T_1$ bzw. des niedrigsten angeregten Singulettzustands $S_1$ der Materialien werden über quantenchemische Rechnungen bestimmt. Zur Berechnung organischer Substanzen ohne Metalle wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31 G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31 G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Die erfindungsgemäßen borenthaltenden Verbindungen, umfassend Strukturen der Formel (I) und/oder (II) können je nach Struktur auch chiral sein. Dies ist insbesondere dann der Fall, wenn sie Substituenten enthalten, beispielsweise Alkyl-, Alkoxy oder Aralkylgruppen, welche ein oder mehrere Stereozentren aufweisen. Da es sich bei der Grundstruktur der borenthaltenden Verbindung auch um eine chirale Struktur handeln kann, ist die Bildung von Diastereomeren und mehreren Enantiomerenpaaren möglich. Die erfindungsgemäßen Verbindungen umfassen dann sowohl die Mischungen der verschiedenen Diastereomere bzw. die entsprechenden Racemate wie auch die einzelnen isolierten Diastereomere bzw. Enantiomere.

Vorzugsweise kann die Verbindung in Form einer Enantiomerenmischung, besonders bevorzugt einer Diasteromerenmischung vorliegen. Hierdurch können die Eigenschaften von elektronischen Vorrichtungen, die unter Verwendung der erfindungsgemäßen Verbindungen erhältlich sind, unerwartet gesteigert werden. Zu diesen Eigenschaften gehören insbesondere die Lebensdauer der Vorrichtungen.

Besonders bevorzugte erfindungsgemäße Verbindungen (Verbindungen 1-3) und auch nicht erfindungsgemäße Verbindungen (Verbindungen 4-40) umfassen Strukuren gemäß den folgenden Formeln 1 bis 40.

| | |
|---|---|
| 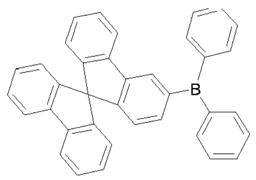 | 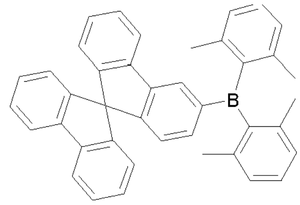 |
| 1 | 2 |
| 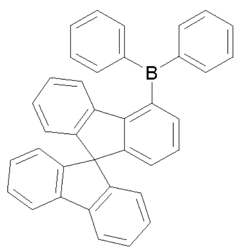 | 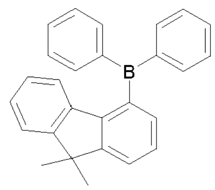 |
| 3 | 4 |
| 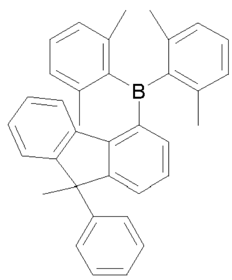 | 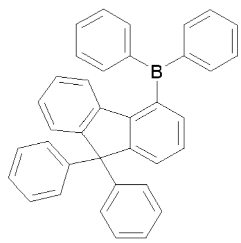 |
| 5 | 6 |

(fortgesetzt)

| | |
|---|---|
| 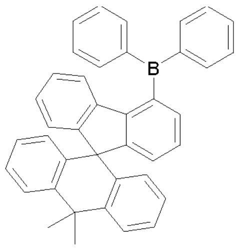 | 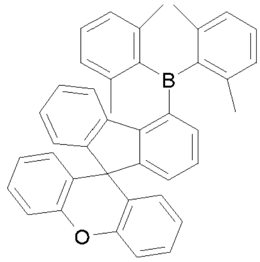 |
| 7 | 8 |
| 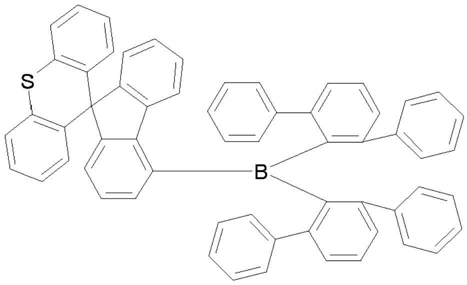 | 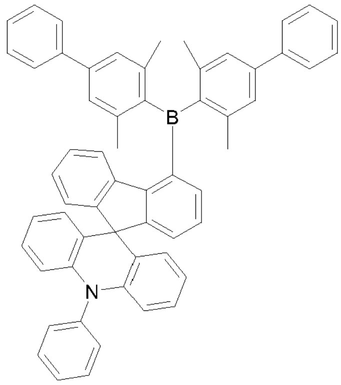 |
| 9 | 10 |
| 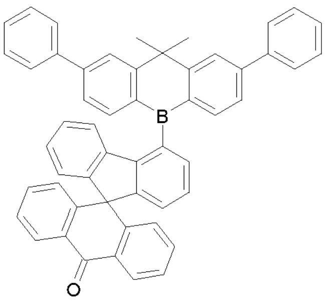 | 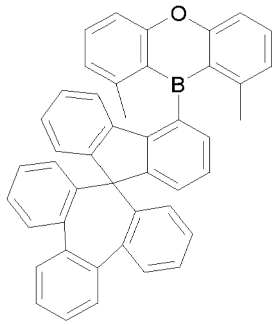 |
| 11 | 12 |
| 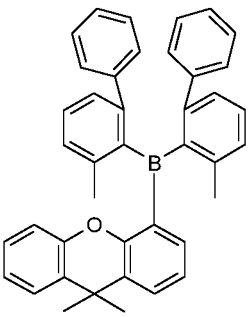 | 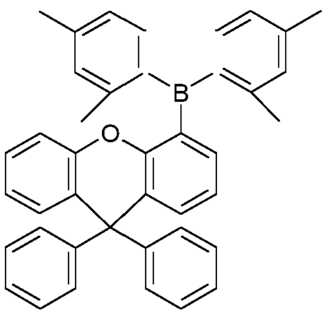 |
| 13 | 14 |

(fortgesetzt)

| | |
|---|---|
| 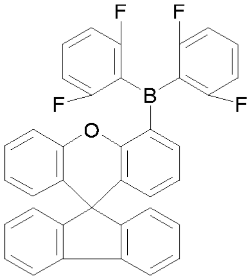 | 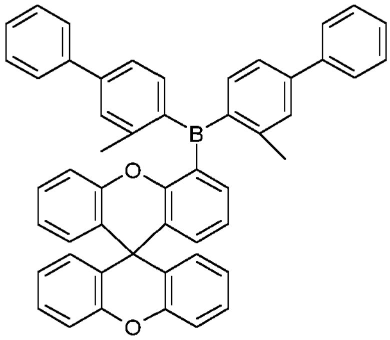 |
| 15 | 16 |
| 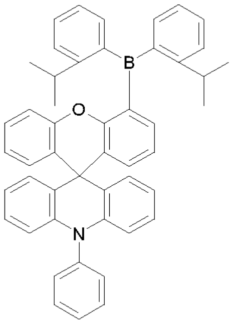 | 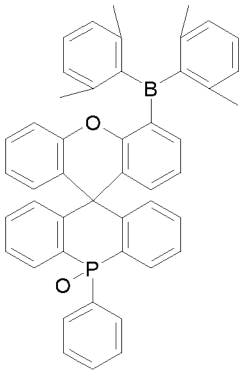 |
| 17 | 18 |
| 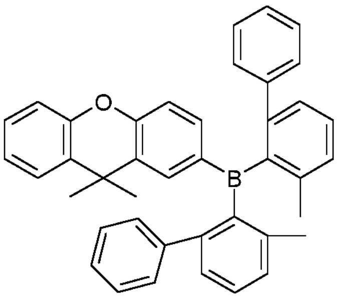 | 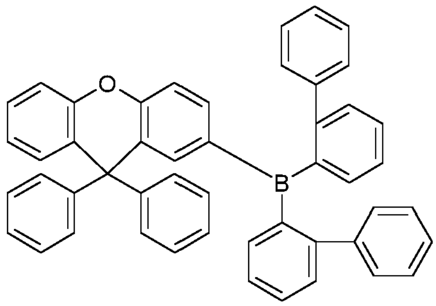 |
| 19 | 20 |
| 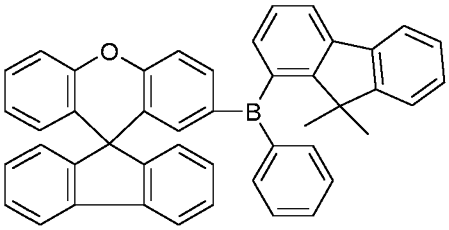 | 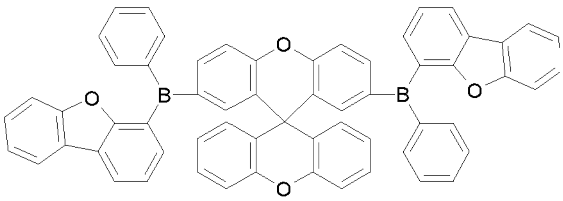 |
| 21 | 22 |

(fortgesetzt)

| | |
|---|---|
| 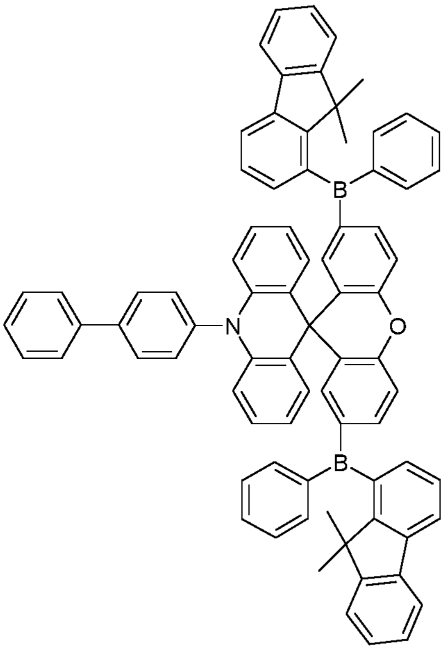 | 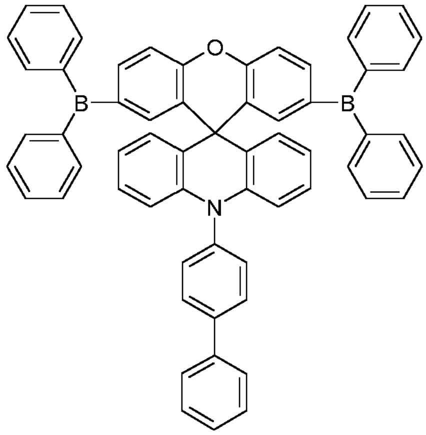 |
| 23 | 24 |
| 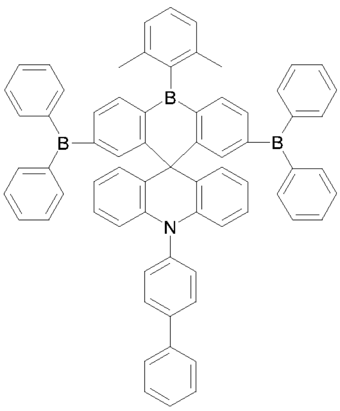 | 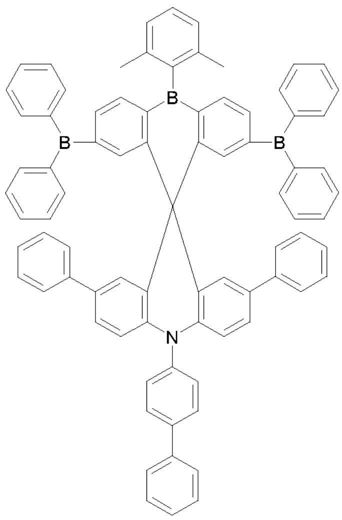 |
| 25 | 26 |

(fortgesetzt)

| | |
|---|---|
| 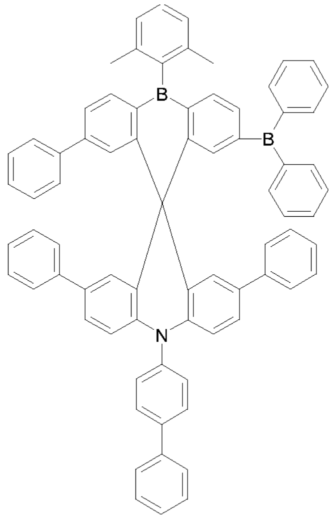 | 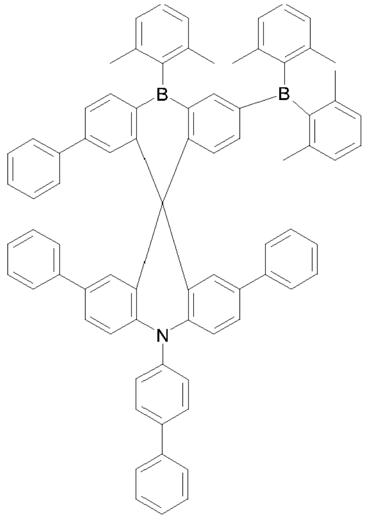 |
| 27 | 28 |
| 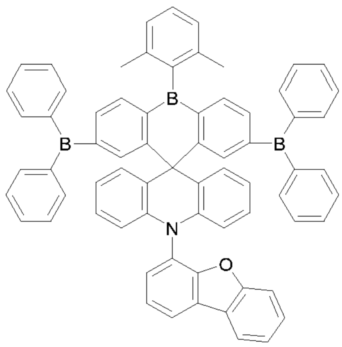 | 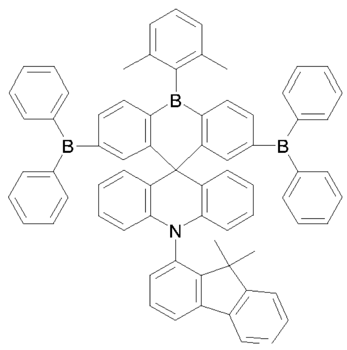 |
| 29 | 30 |
| 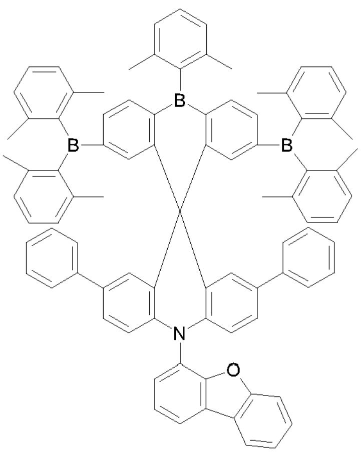 | 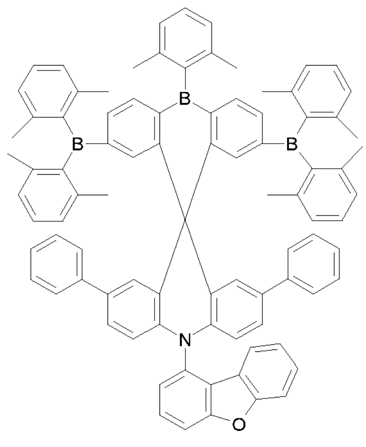 |
| 31 | 32 |

(fortgesetzt)

| | |
|---|---|
| 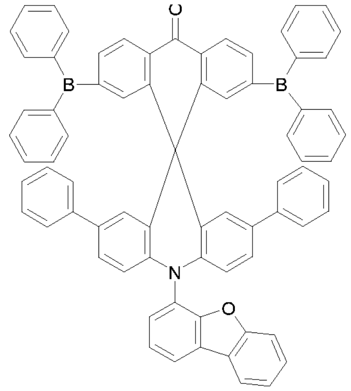 | 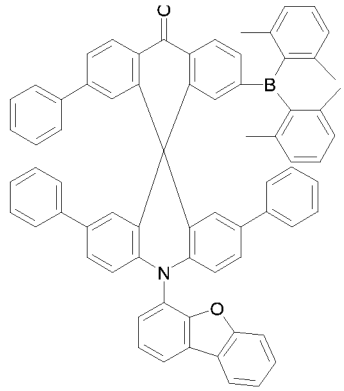 |
| 33 | 34 |
| 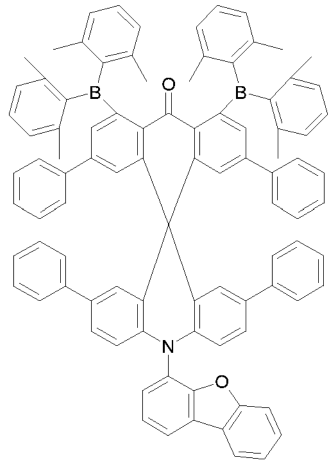 | 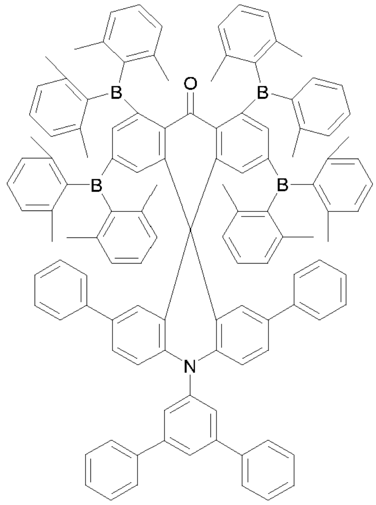 |
| 35 | 36 |
| 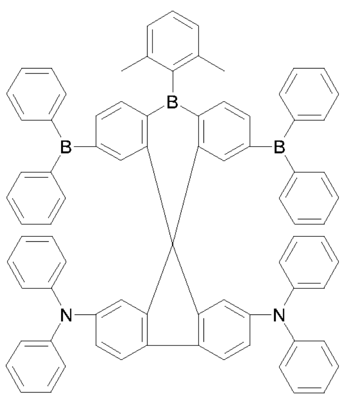 | 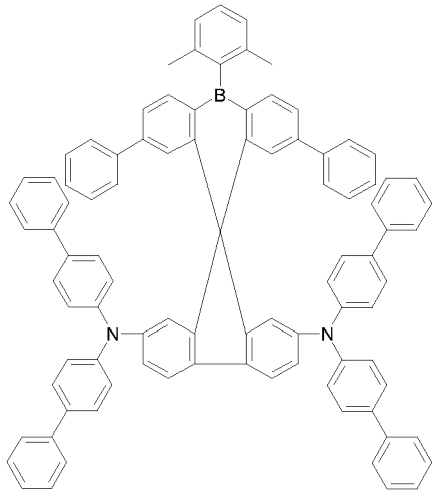 |
| 37 | 38 |

(fortgesetzt)

| | |
|---|---|
| 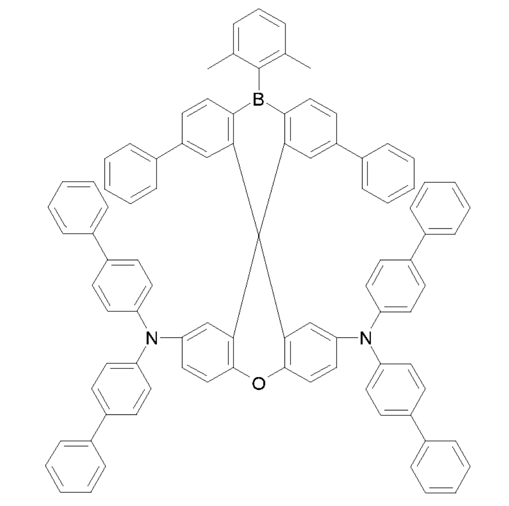 | 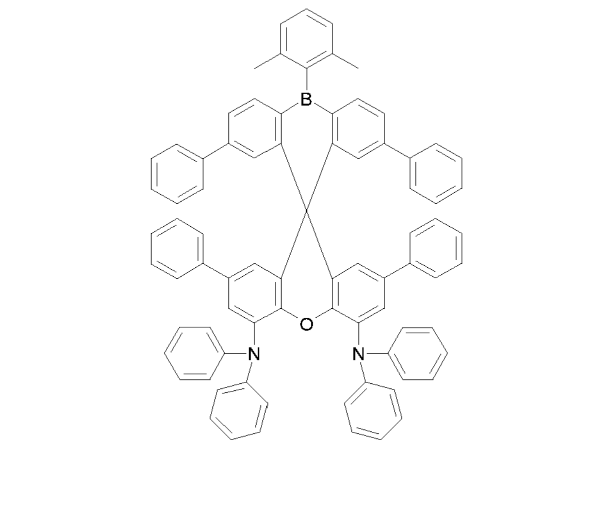 |
| 39 | 40 |

Unter der Voraussetzung, dass die in Anspruch 1 genannten Bedingungen eingehalten werden, sind die oben genannten bevorzugten Ausführungsformen beliebig miteinander kombinierbar. In einer besonders bevorzugten Ausführungsform der Erfindung gelten die oben genannten bevorzugten Ausführungsformen gleichzeitig.

Die erfindungsgemäßen Verbindungen sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der erfindungsgemäßen Verbindungen durch Umsetzung mindestens einer Aryllithium-Verbindung mit mindestens einem Halogenboran und/oder mindestens einem Borinsäureester hergestellt werden.

Eine Darstellung von erfindungsgemäßen Verbindungen ergibt sich beispielhaft gemäß folgendem Schema:

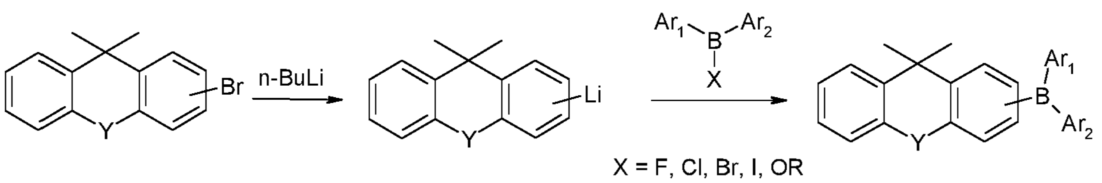


Ein weiterer Gegenstand der vorliegenden Erfindung ist ein Verfahren zur Darstellung von erfindungsgemäßen Verbindungen via Kopplungsreaktionen. Beispielhaft sei dieses Verfahren via Suzuki-Kupplung aus Arylbromiden und Arylboronsäuren dargestellt:

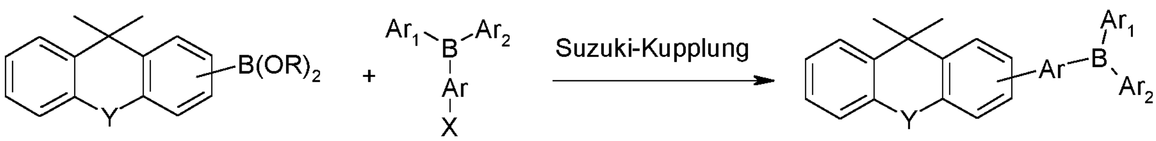


R = OH, O-Alkyl

Besonders geeignete und bevorzugte Kupplungsreaktionen, die alle zu C-C-Verknüpfungen führen, sind solche gemäß BUCHWALD, SUZUKI, YAMAMOTO, STILLE, HECK, NEGISHI, SONOGASHIRA und HIYAMA.

Die Grundlagen der zuvor dargelegten Herstellungsverfahren sind im Prinzip aus der Literatur für ähnliche Verbindungen bekannt und können vom Fachmann leicht zur Herstellung der erfindungsgemäßen Verbindungen angepasst werden.

Durch diese Verfahren, gegebenenfalls gefolgt von Aufreinigung, wie z. B. Umkristallisation oder Sublimation, lassen sich die erfindungsgemäßen Verbindungen, umfassend Strukturen gemäß Formel (I) und/oder Formel (II) in hoher Reinheit, bevorzugt mehr als 99 % (bestimmt mittels $^1$H-NMR und/oder HPLC) erhalten.

Die erfindungsgemäßen Verbindungen können auch geeignete Substituenten aufweisen, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, die eine Löslichkeit in gängigen organischen Lösemitteln bewirken, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren. Weiterhin ist festzuhalten, dass die erfindungsgemäßen Verbindungen bereits eine gesteigerte Löslichkeit in diesen Lösungsmitteln besitzen.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Oligomere, Polymere oder Dendrimere können eine oder mehrere der oben aufgeführten Strukturen oder erfindungsgemäße Verbindungen enthalten, wobei ein oder mehrere Bindungen der erfindungsgemäßen Verbindungen zum Polymer, Oligomer oder Dendrimer vorhanden sind. Je nach Verknüpfung der Strukturen bzw. der Verbindungen bilden diese daher eine Seitenkette des Oligomers oder Polymers oder sind in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Die Copolymere können die genannten Einheiten zu 0.01 bis 99.9 mol% oder von 5 bis 90 mol% odrer von 20 bis 80 mol% enthalten. Geeignete Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Ferner können die vorliegenden Verbindungen ein relativ geringes Molekulargewicht aufweisen. Ein weiterer Gegenstand der vorliegenden Erfindung ist demgemäß eine Verbindung, die ein Molekulargewicht von vorzugsweise höchstens 10000 g/mol, besonders bevorzugt höchstens 5000 g/mol und speziell bevorzugt höchstens 3000 g/mol aufweist.

Weiterhin zeichnen sich bevorzugte Verbindungen dadurch aus, dass diese sublimierbar sind. Diese Verbindungen weisen im Allgemeinen eine Molmasse von weniger als ca. 1200 g/mol auf.

Von besonderem Interesse sind des Weiteren erfindungsgemäße Verbindungen, die sich durch eine hohe Glasübergangstemperatur auszeichnen. In diesem Zusammenhang sind insbesondere erfindungsgemäße Verbindungen bevorzugt, die eine Glasübergangstemperatur von mindestens 70°C, besonders bevorzugt von mindestens 110°C, ganz besonders bevorzugt von mindestens 125°C und insbesondere bevorzugt von mindestens 150°C aufweisen, bestimmt nach DIN 51005.

Nochmals ein weiterer Gegenstand der vorliegenden Erfindung ist eine Formulierung, enthaltend eine erfindungsgemäße Verbindung und mindestens eine weitere Verbindung. Die weitere Verbindung kann vorzugsweise ein Lösemittel sein. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Geeignete und bevorzugte Lösungsmittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-tetramethylbenzol, 1-Methylnaphtalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzyl ether, Diethylenglycolbutylmethylether, Triethylenglycolbutylmethylether, Diethylenglycoldibutylether, Triethylenglycoldimethylether, Diethylen-glycolmonobutylether, Tripropylenglycoldimethylether, Tetraethylenglycol-dimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser

Lösungsmittel.

Nochmals ein weiterer Gegenstand der vorliegenden Erfindung ist eine Zusammensetzung enthaltend eine erfindungsgemäße Verbindung und wenigstens ein weiteres organisch funktionelles Material ausgewählt aus der Gruppe bestehend aus fluoreszierenden Emittern, phosphoreszierenden Emittern, Host Materialien, Matrix-Materialien, Elektronentransportmaterialien, Elektroneninjektionsmaterialien, Lochleitermaterialien, Lochinjektionsmaterialien, Elektronenblockiermaterialien und Lochblockiermaterialien.

Die vorliegenden Erfindung betrifft daher auch eine Zusammensetzung enthaltend wenigstens eine erfindungsgemäße Verbindung sowie wenigstens ein weiteres Matrixmaterial. Gemäß einem besonderen Aspekt der vorliegenden Erfindung weist das weitere Matrixmaterial lochtransportierende Eigenschaften auf.

Ein weiterer Gegenstand der vorliegenden stellt eine Zusammensetzung dar, enthaltend wenigstens eine erfindungsgemäße Verbindung sowie wenigstens ein wide band gap Material, wobei unter wide band gap Material ein Material im Sinne der Offenbarung von US 7,294,849 verstanden wird. Diese Systeme zeigen besondere vorteilhafte Leistungsdaten in elektrolumineszierenden Vorrichtungen.

Vorzugsweise kann die zusätzliche Verbindung eine Bandlücke (band gap) von 2.5 eV oder mehr, bevorzugt 3.0 eV oder mehr, ganz bevorzugt von 3.5 eV oder mehr aufweisen. Die Bandlücke kann unter anderem durch die Energieniveaus des highest occupied molecular orbital (HOMO) und des lowest unoccupied molecular orbital (LUMO) berechnet werden, wie dies zuvor beispielhaft dargelegt wurde.

Die vorliegende Erfindung betrifft auch eine Zusammensetzung umfassend wenigstens eine erfindungsgemäße Verbindung sowie wenigstens einen phosphoreszierende Emitter, wobei unter dem Begriff phosphoreszierende Emitter auch phosphoreszierende Dotanden verstanden werden.

Vom Begriff phosphoreszierende Dotanden sind typischerweise Verbindungen umfasst, bei denen die Lichtemission durch einen spinverbotenen Übergang erfolgt, beispielsweise einen Übergang aus einem angeregten Triplettzustand oder einem Zustand mit einer höheren Spinquantenzahl, beispielsweise einem Quintett-Zustand.

Als phosphoreszierende Dotanden eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende Dotanden Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Dabei werden im Sinne der vorliegenden Anmeldung alle lumineszierenden Iridium-, Platin- oder Kupferkomplexe als phosphoreszierende Verbindungen angesehen. Beispiele für phosphoreszierende Dotanden sind in einem folgenden Abschnitt aufgeführt.

Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist.

Bevorzugte phosphoreszierende Dotanden zur Verwendung in Mixed-Matrix-Systemen sind die im Folgenden angebenen bevorzugten phosphoreszierenden Dotanden.

Beispiele für phosphoreszierende Dotanden können den Anmeldungen WO 2000/70655, WO 2001/41512, WO 2002/02714, WO 2002/15645, EP 1191613, EP 1191612, EP 1191614, WO 2005/033244, WO 2005/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind, zur Verwendung in den erfindungsgemäßen Vorrichtungen.

Explizite Beispiele für phosphoreszierende Dotanden sind in der folgenden Tabelle aufgeführt.

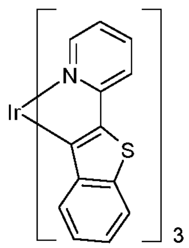

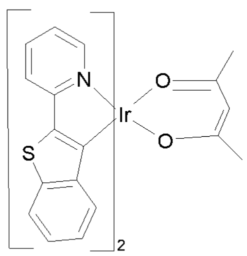

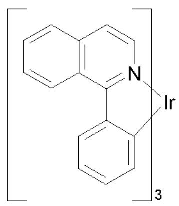

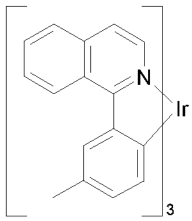

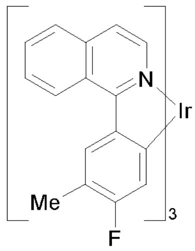

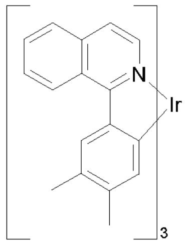

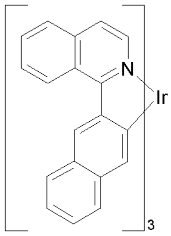

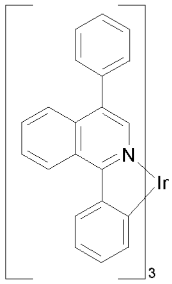

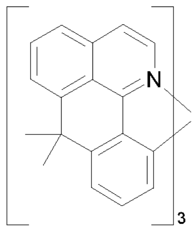

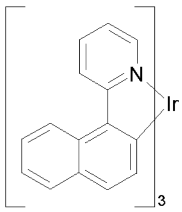

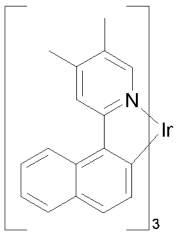

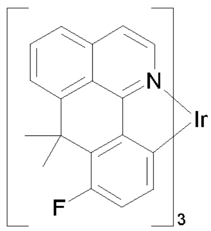

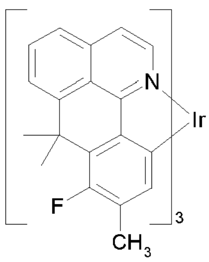

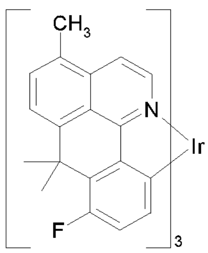

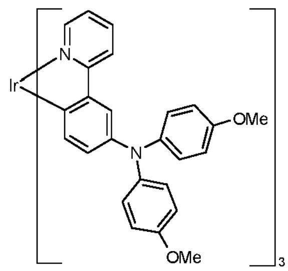

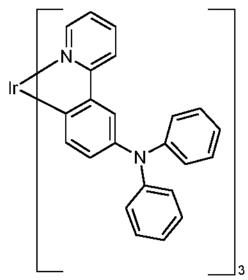

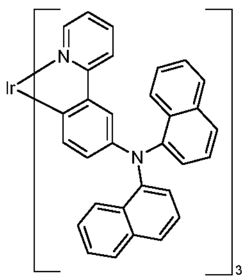

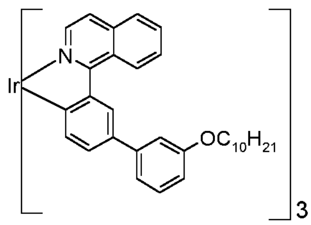

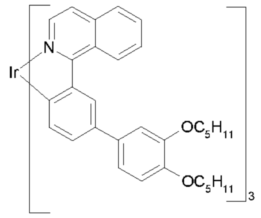
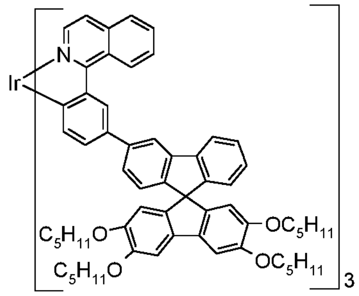
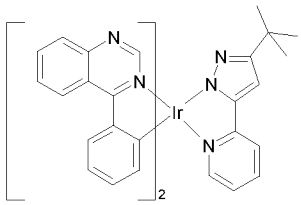

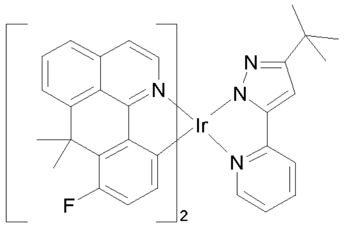
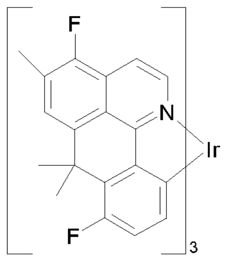
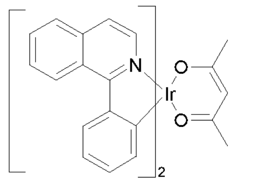

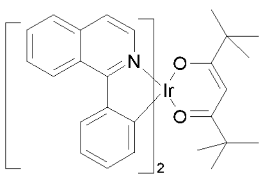
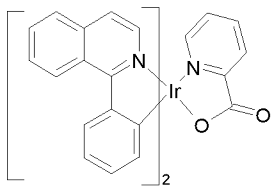
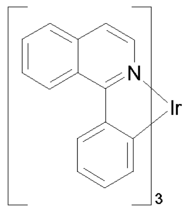

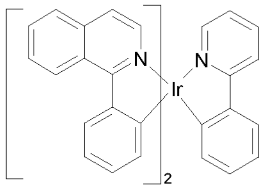
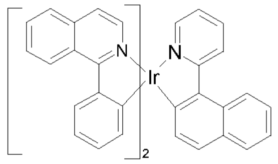
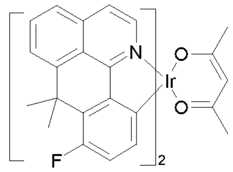

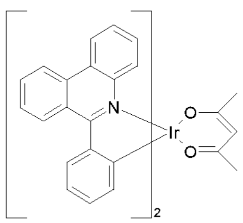
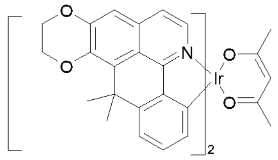
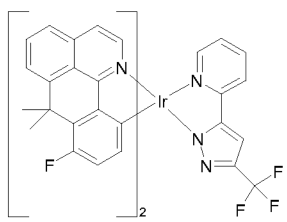

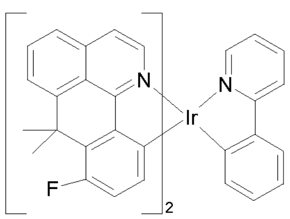
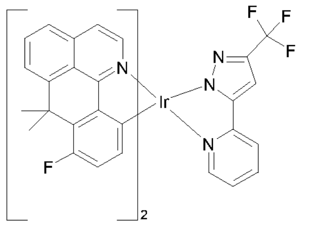
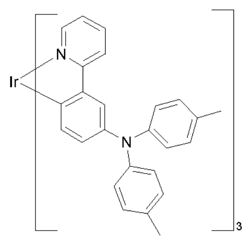

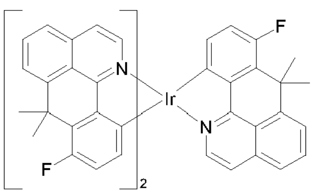

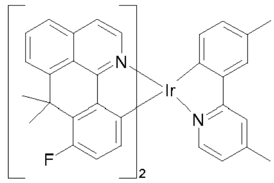

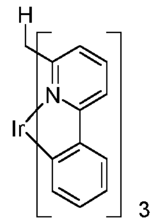

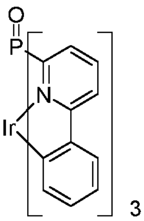

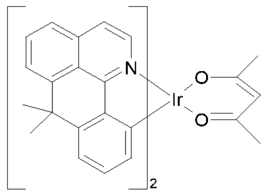

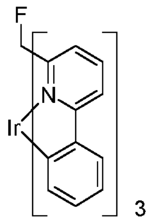

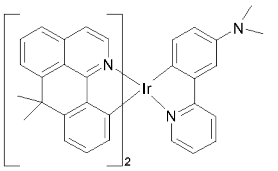

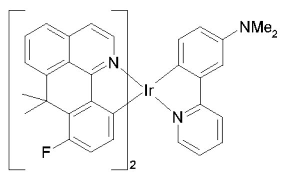

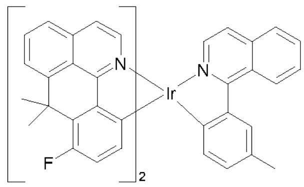

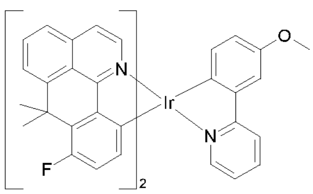

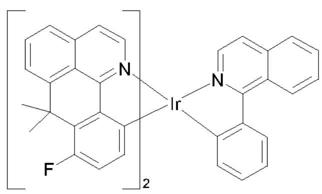

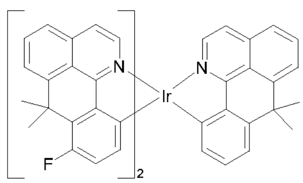

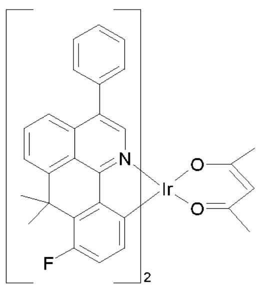

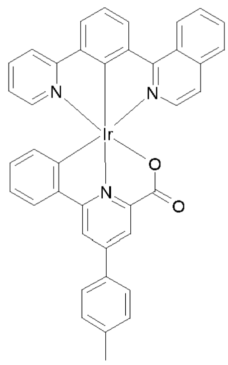

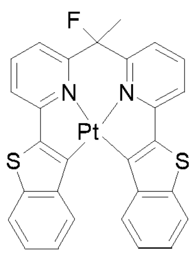

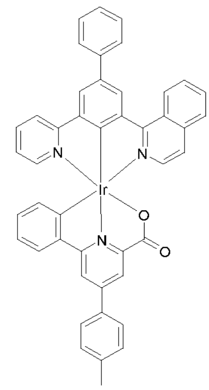

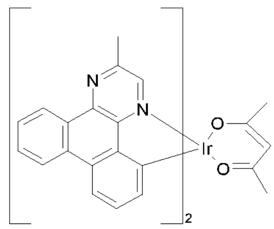

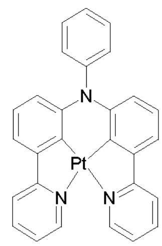

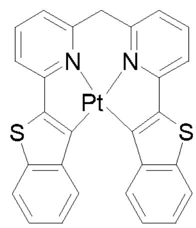

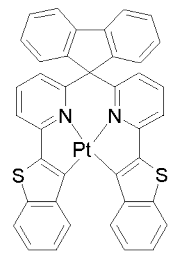

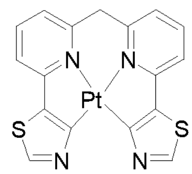

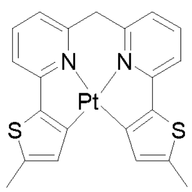

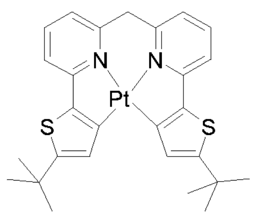

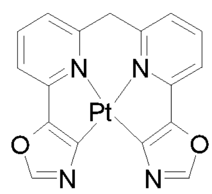

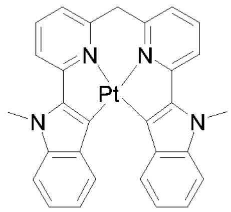

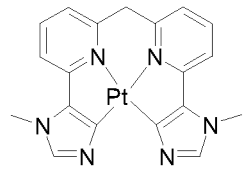

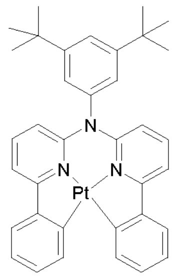

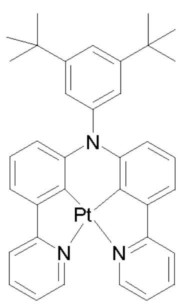

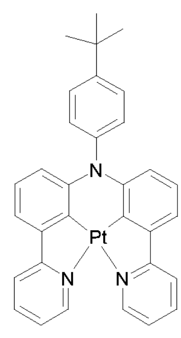

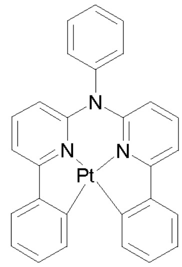

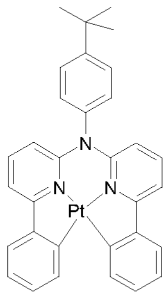
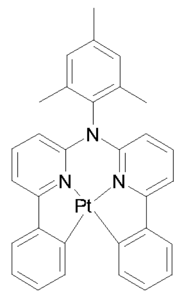
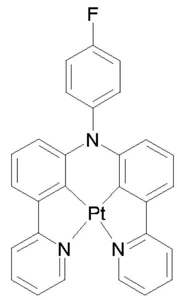

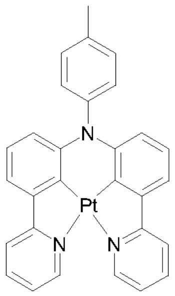
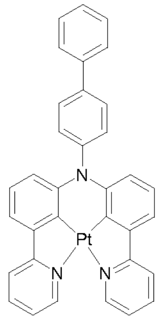
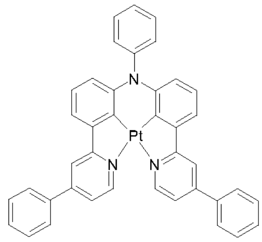

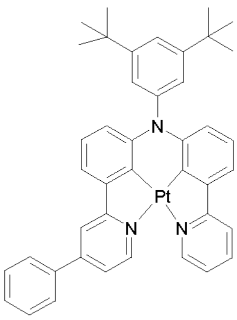
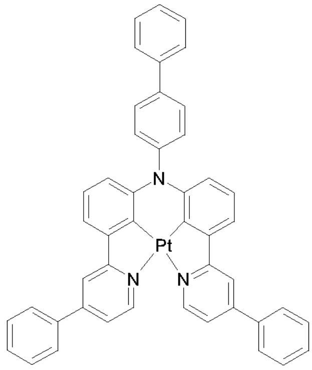
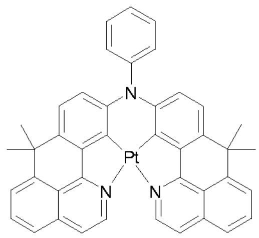

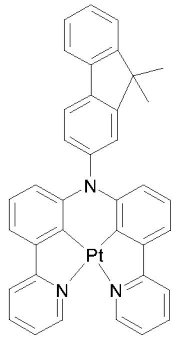
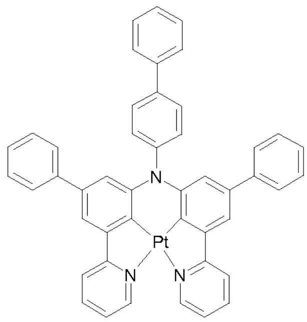
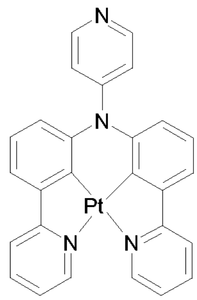

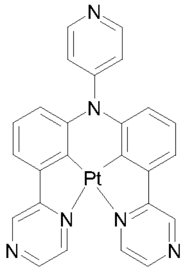
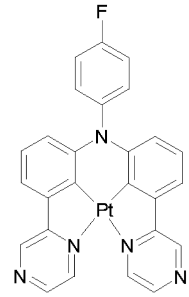
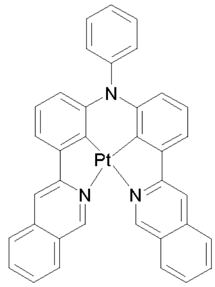

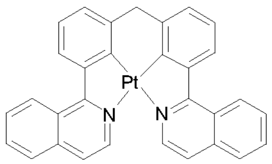
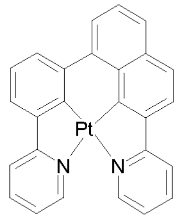
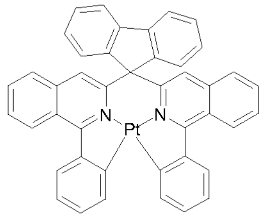

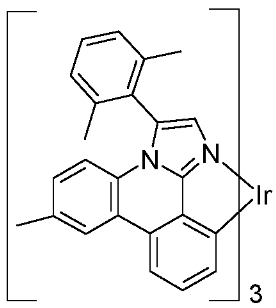
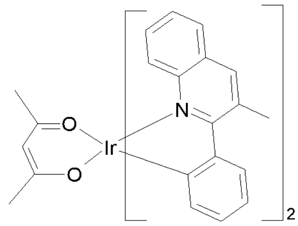
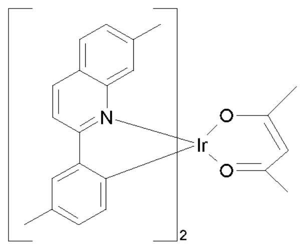

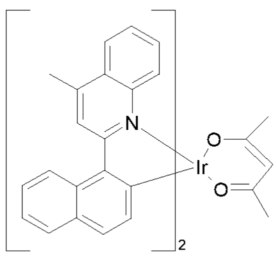
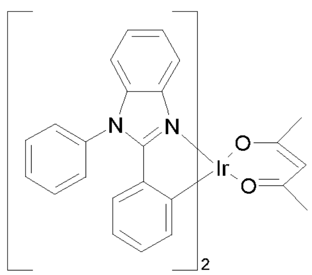
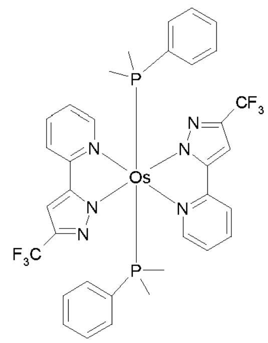

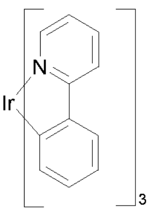
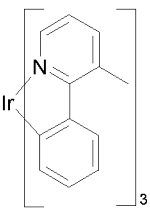
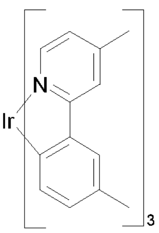

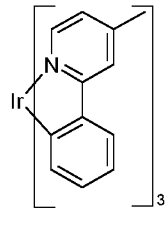
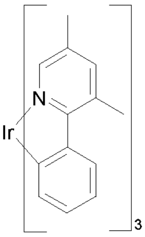
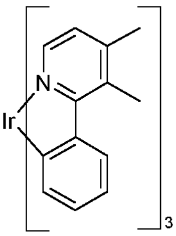

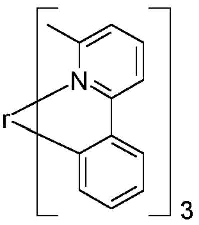
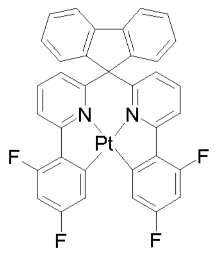
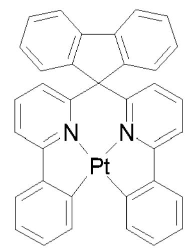

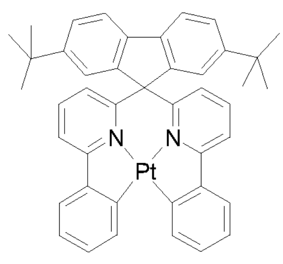
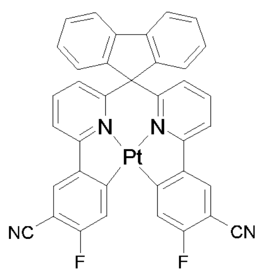
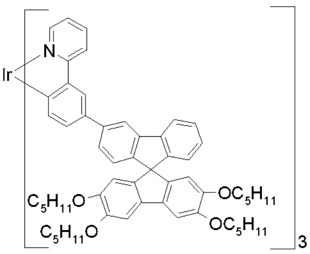

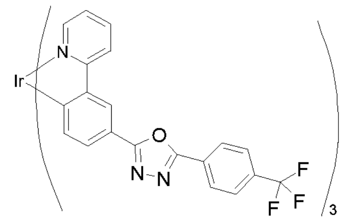
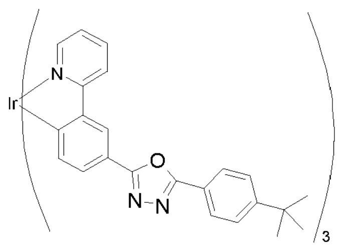
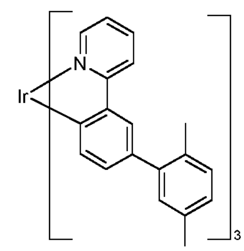

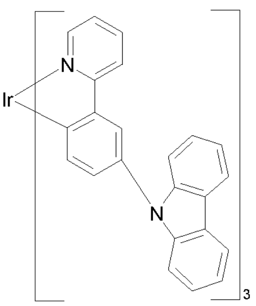
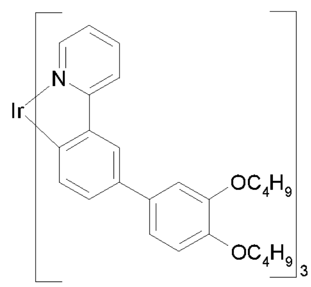
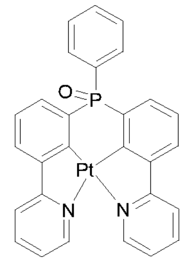

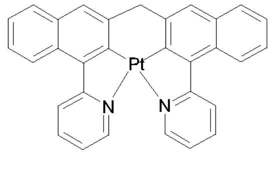
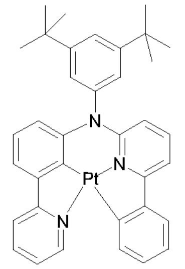
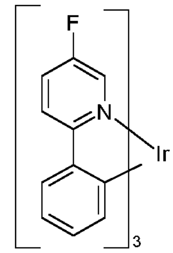

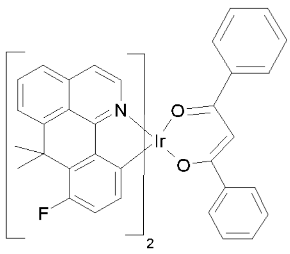
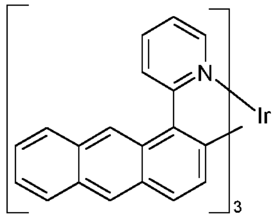
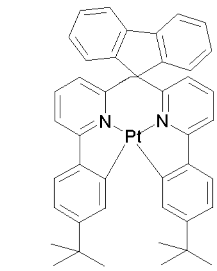
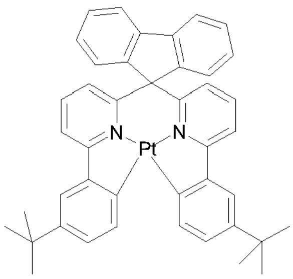
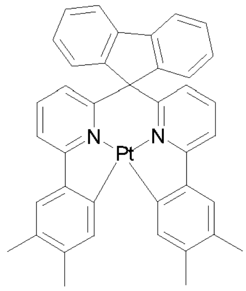
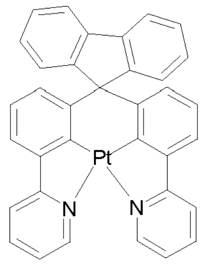
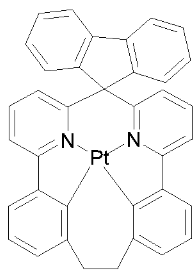
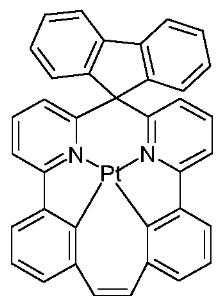
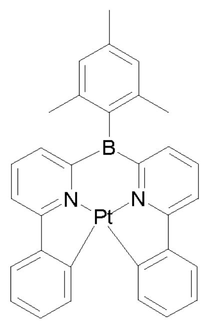
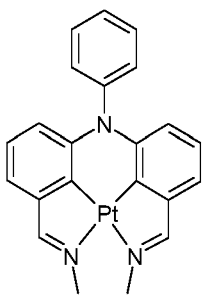
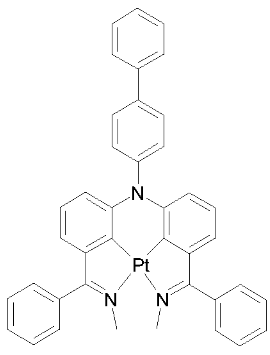
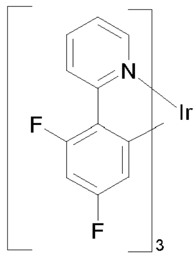
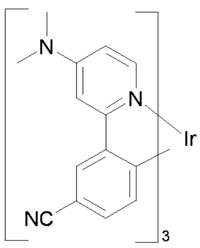
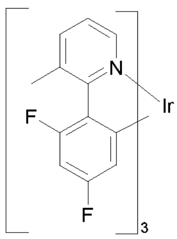
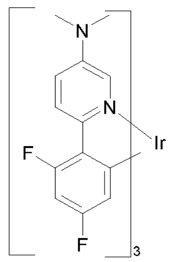

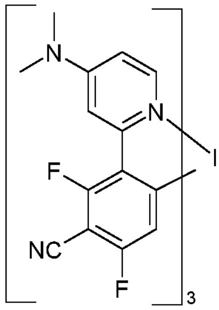
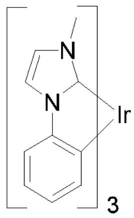
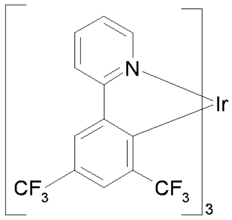

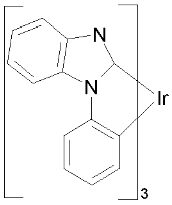
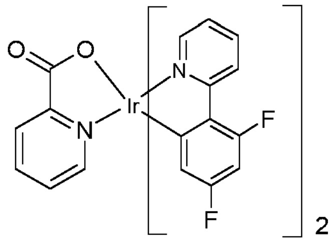
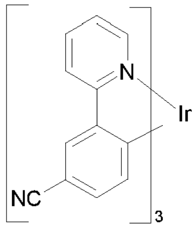

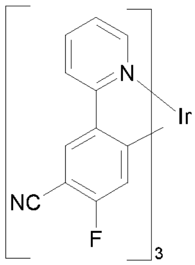
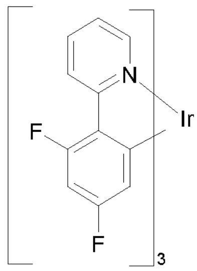
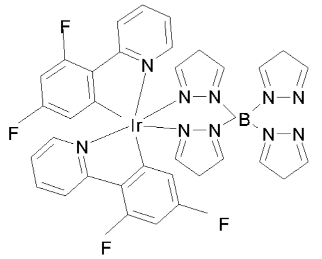

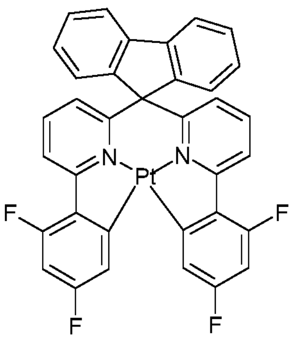
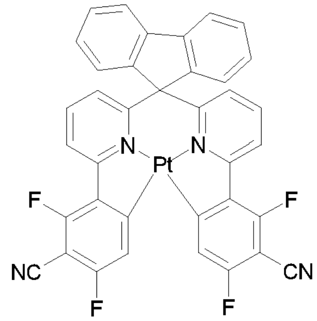
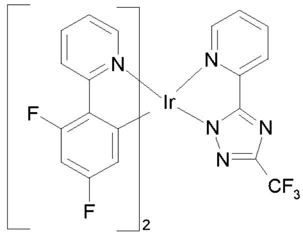

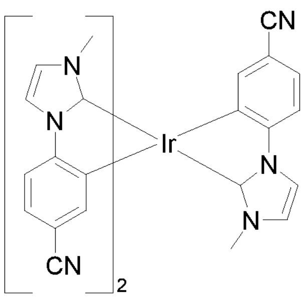
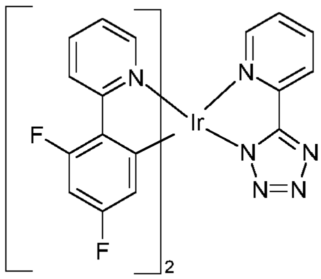
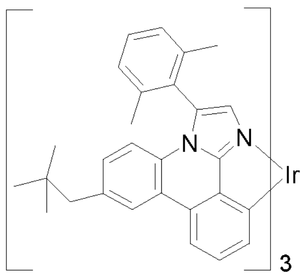

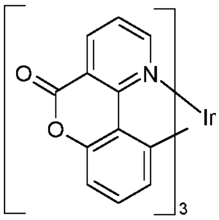

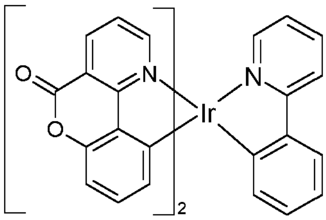

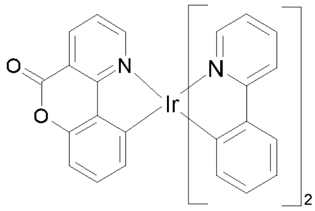

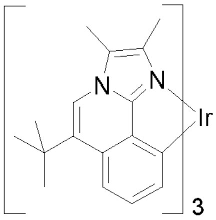

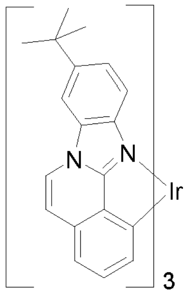

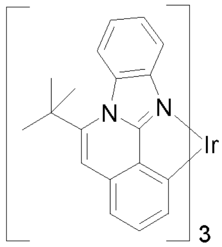

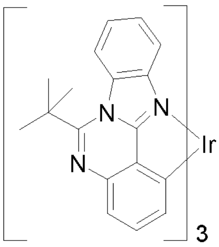

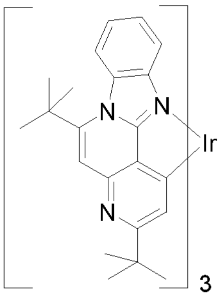

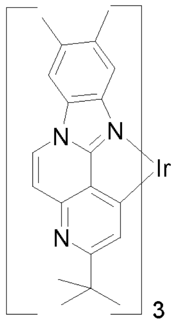

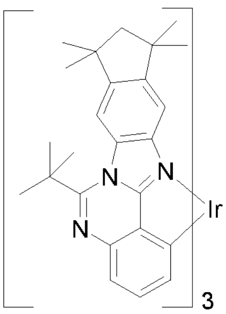

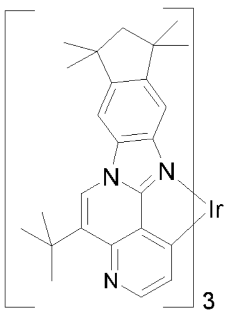

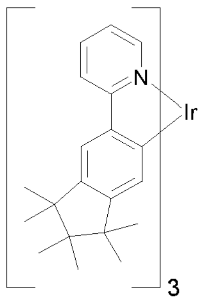

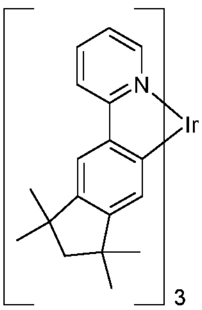

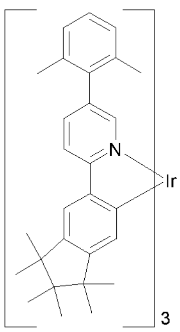

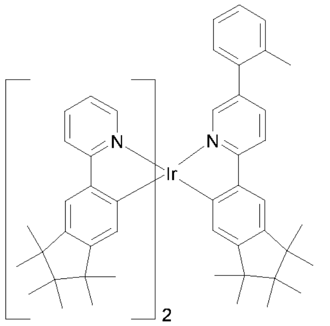

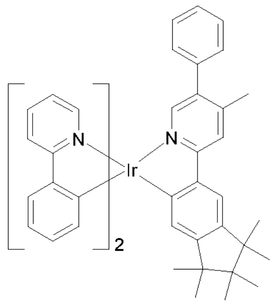
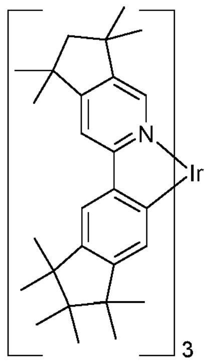
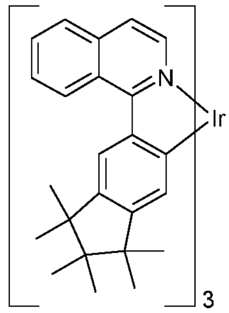
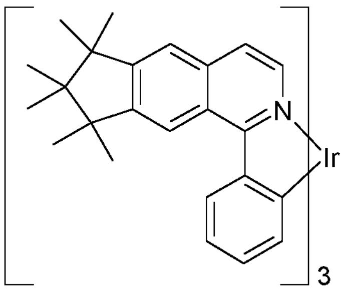
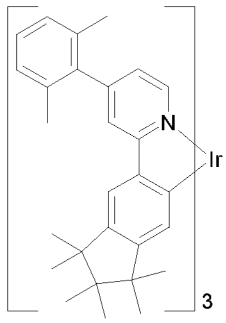
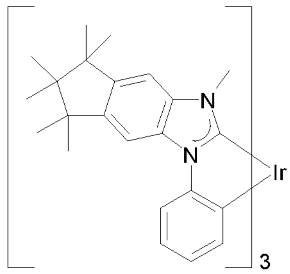
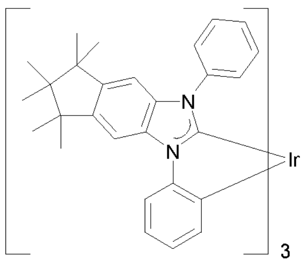
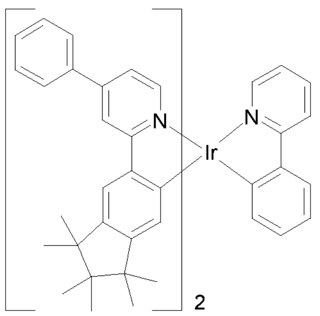
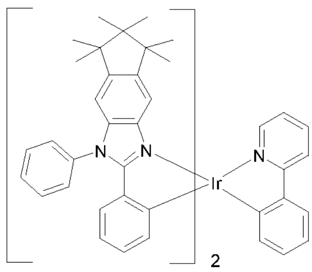
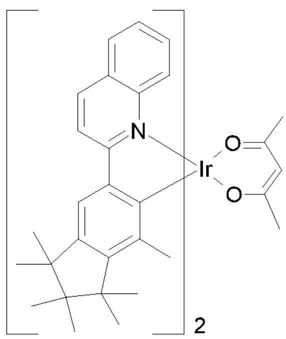
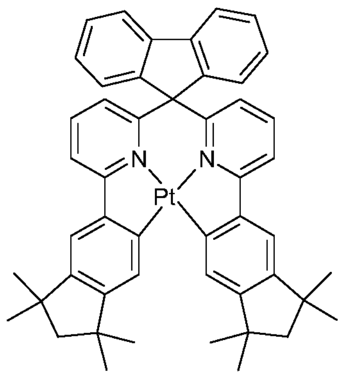
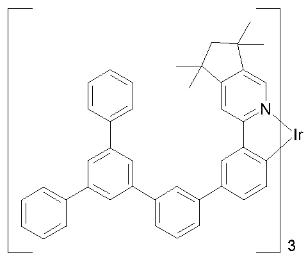

Die oben beschriebenen erfindungsgemäßen Verbindung bzw. die oben aufgeführten bevorzugten Ausführungsformen können in einer elektronischen Vorrichtung bevorzugt als aktive Komponente verwendet werden. Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine erfindungsgemäße Verbindung enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen

(O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung, umfassend Strukturen der Formeln (I) und/oder (II). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie $MoO_3$ oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die efindungsgemäße Verbindung bzw. die oben aufgeführten bevorzugten Ausführungsformen als Matrixmaterial, vorzugsweise als elektronenleitendes Matrixmaterial in einer oder mehreren emittierenden Schichten, bevorzugt in Kombination mit einem weiteren Matrixmaterial, vorzugsweise einem lochleitenden Matrixmaterial. Eine emittierende Schicht umfasst mindestens eine emittierende Verbindung.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum.

Besonders bevorzugt kann eine erfindungsgemäße Verbindung in einer bevorzugten Ausführungsform als Matrixmaterial in einer Emissionsschicht einer organischen elektronischen Vorrichtung, insbesondere in einer organischen elektrolumineszierenden Vorrichtung, beispielsweise in einer OLED oder OLEC, eingesetzt. Dabei ist das Matrixmaterial enthaltend eine erfindungsgemäße Verbindung in der elektronischen Vorrichtung in Kombination mit einem oder mehreren Dotanden, vorzugsweise phosphoreszierenden Dotanden, vorhanden.

Der Anteil des Matrixmaterials in der emittierenden Schicht beträgt in diesem Fall zwischen 50.0 und 99.9 Vol.-%, bevorzugt zwischen 80.0 und 99.5 Vol.-% und besonders bevorzugt für fluoreszierende emittierende Schichten zwischen 92.0 und 99.5 Vol.-% sowie für phosphoreszierende emittierende Schichten zwischen 85.0 und 97.0 Vol.-%.

Entsprechend beträgt der Anteil des Dotanden zwischen 0.1 und 50.0 Vol.-%, bevorzugt zwischen 0.5 und 20.0 Vol.-% und besonders bevorzugt für fluoreszierende emittierende Schichten zwischen 0.5 und 8.0 Vol.-% sowie für phosphoreszierende emittierende Schichten zwischen 3.0 und 15.0 Vol.-%.

Eine emittierende Schicht einer organischen Elektrolumineszenzvorrichtung kann auch Systeme umfassend mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

In einer weiteren bevorzugten Ausführungsform der Erfindung werden die erfindungsgemäßen Verbindungn als eine Komponente von Mixed-Matrix-Systemen verwendet. Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt 1:20 bis 1:1, besonders bevorzugt 1:10 bis 1:1 und ganz besonders bevorzugt 1:4 bis 1:1 vorliegen. Bevorzugt werden Mixed-Matrix-Systeme in phosphoreszierenden organischen Elektrolumineszenzvorrichtungen eingesetzt. Genauere Angaben zu Mixed-Matrix-Systemen sind unter anderem in der Anmeldung WO 2010/108579 enthalten.

Besonders geeignete Matrixmaterialien, welche in Kombination mit den erfindungsgemäßen Verbindungen als Matrixkomponenten eines Mixed-Matrix-Systems verwendet werden können, sind ausgewählt aus den unten angegebenen bevorzugten Matrixmaterialien für phosphoreszierende Dotanden oder den bevorzugten Matrixmaterialien für fluoreszierende Dotanden, je nachdem welche Art von Dotand im mixed-Matrix-System eingesetzt wird.

Ferner ist eine elektronische Vorrichtung, vorzugsweise eine organische Elektrolumineszenzvorrichtung Gegenstand der vorliegenden Erfindung, die eine oder mehrere erfindungsgemäße Verbindungen und/oder mindestens ein erfindungsgemäßes Oligomer, Polymer oder Dendrimer in einer oder mehreren elektronenleitenden Schichten umfasst, als elektronenleitende Verbindung.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. $Al/Ni/NiO_x$, $Al/PtO_x$) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise $MoO_3$ oder $WO_3$, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der

Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine elektronischen Vorrichtung, insbesondere eine organische Elektrolumineszenzvorrichtung, welche dadurch gekennzeichnet ist, dass eine oder mehrere Schichten mit einem Sublimationsverfahren beschichtet werden. Dabei werden die Materialien in Vakuum-Sublimationsanlagen bei einem Anfangsdruck von üblicherweise kleiner $10^{-5}$ mbar, bevorzugt kleiner $10^{-6}$ mbar aufgedampft. Es ist auch möglich, dass der Anfangsdruck noch geringer oder noch höher ist, beispielsweise kleiner $10^{-7}$ mbar.

Bevorzugt ist ebenfalls eine elektronischen Vorrichtung, insbesondere eine organische Elektrolumineszenzvorrichtung, welche dadurch gekennzeichnet ist, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronischen Vorrichtung, insbesondere eine organische Elektrolumineszenzvorrichtung, welche dadurch gekennzeichnet ist, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die elektronischen Vorrichtung, insbesondere die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine efindungsgemäße Verbindung und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf elektronischen Vorrichtungen, insbesondere organische Elektrolumineszenzvorrichtungen enthaltend efindungsgemäße Verbindungen bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:

1. Elektronischen Vorrichtungen, insbesondere organische Elektrolumineszenzvorrichtungen enthaltend erfindungsgemäße Verbindungen, insbesondere als elektronenleitende Materialien, weisen eine sehr gute Lebensdauer auf.

2. Elektronischen Vorrichtungen, insbesondere organische Elektrolumineszenzvorrichtungen enthaltend erfindungsgemäße Verbindungen als elektronenleitende Materialien weisen eine hervorragende Effizienz auf. Insbesondere ist die Effizienz deutlich höher gegenüber analogen Verbindungen, die keine Struktureinheit gemäß den erfindungsgemäßen Verbindungen enthalten.

3. Die erfindungsgemäßen Verbindungen zeigen eine sehr hohe Stabilität und führen zu Verbindungen mit einer sehr hohen Lebensdauer.

4. Mit den erfindungsgemäßne Verbindungen kann in elektronischen Vorrichtungen, insbesondere organische Elektrolumineszenzvorrichtungen die Bildung von optischen Verlustkanäle vermieden werden. Hierdurch zeichnen sich diese Vorrichtungen durch eine hohe PL- und damit hohe EL-Effizienz von Emittern bzw. eine ausgezeichnete Energieübertragung der Matrices auf Dotanden aus.

5. Die Verwendung von erfindungsgemäßen Verbindungen in Schichten elektronischer Vorrichtungen, insbesondere organischer Elektrolumineszenzvorrichtungen führt zu einer hohen Mobilität der Elektron-Leiterstrukturen.

6. Die erfindungsgemäßen Verbindungen zeichnen sich durch eine ausgezeichnete thermische Stabilität aus, wobei Verbindungen mit einer Molmasse von weniger als ca. 1200 g/mol gut sublimierbar sind.

7. Die erfindungsgemäßen Verbindungen weisen eine ausgezeichnete Glasfilmbildung auf.

8. Die erfindungsgemäßen Verbindungen bilden aus Lösungen sehr gute Filme.

9. Die erfindungsgemäßen Verbindungen weisen zu überraschend hohe Triplett-Niveau $T_1$ auf.

Diese oben genannten Vorteile gehen nicht mit einer Verschlechterung der weiteren elektronischen Eigenschaften einher.

Ein weiterer Gegenstand der vorliegenden Erfindung ist die Verwendung einer erfindungsgemäßen Verbindung und/oder eines erfindungsgemäßen Oligomers, Polymers oder Dendrimers in einer elektronischen Vorrichtung als Lochblockiermaterial, Elektroneninjektionsmaterial, und/oder Elektronentransportmaterial.
Es sei darauf hingewiesen, dass Variationen der in der vorliegenden Erfindung beschriebenen Ausführungsformen unter den Umfang dieser Erfindung fallen, aber nur insofern sie in den Schutzbereich der Ansprüche fallen. Dem Fachmann ist bekannt, dass in der vorliegenden Erfindung offenbarte Merkmale durch alternative Merkmale, die demselben, einem äquivalenten oder einem ähnlichen Zweck dienen, ausgetauscht werden können und als Beispiel einer generischen Reihe oder als äquivalentes oder ähnliches Merkmal zu betrachten sind. Der Schutzanspruch der Erfindung wird durch die Ansprüche definiert.

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

Der Fachmann kann aus den Schilderungen ohne erfinderisches Zutun weitere erfindungsgemäße elektronische Vorrichtungen herstellen und somit die Erfindung im gesamten beanspruchten Bereich ausführen.

## Beispiele

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### Allgemeines Darstellungsverfahren:

### A: Synthese der Synthone S:

### Beispiel S1: 4-Brorn-spiro-9,9'-bifluoren

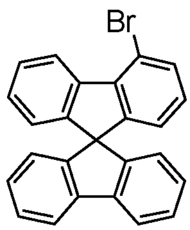

Eine auf -78 °C gekühlte Lösung von 250 g (785 mmol) 2,2'-Dibrombiphenyl in 2000 ml THF wird unter Rühren tropfenweise mit 318 ml n-BuLi, 2.5 M in n-Hexan versetzt und 30 min. nachgerührt. Dann tropft man eine Lösung von 144 g (785 mmol) Fluoren in 1000 ml THF zu, rührt 30 min. nach, entfernt das Kältebad und lässt über Nacht auf Raumtemperatur erwärmen. Man entfernt das Lösungsmittel weitgehend im Vakuum, nimmt den Rückstand in 2000 ml Eisessig auf, fügt 200 ml EtOH und 100 ml konz. Salzsäure zu, und erhitzt die Mischung 2 h unter Rückfluss. Nach Erkalten saugt man vom ausgefallenen Feststoff ab, wäscht diesen zweimal mit je 500 ml Eisessig und dann dreimal mit je 300 ml Ethanol und trocknet im Vakuum. Ausbeute: 265 g (667 mmol), 85%. Reinheit ca. 98 % ig nach NMR.

**B: Synthese der Borane:**

**Variante1 :**

Eine gut gerührte, auf -78 °C gekühlte Lösung bzw. Suspension von 100 mmol eines Monobromids bzw. 50 mmol eines Dibromids, bzw. 33 mmol eines Tribromids bzw. 25 mmol eines Tetrabromids in 1000 ml THF wird tropfenweise so mit 105 mmol n-BuLi, 2.5 M in n-Hexan versetzt, dass die Temperatur -55 °C nicht übersteigt. Nach beendeter Zugabe rührt man 2 h nach, und tropft dann eine Lösung von 110 mmol Fluoroborans in 200 ml THF so zu, dass die Temperatur -55 °C nicht übersteigt. Man rührt 1 h bei - 78°C nach und lässt dann langsam auf Raumtemperatur erwärmen. Nach Zugabe von 50 ml Methanol entfernt man das Lösungsmittel weitgehend im Vakuum, nimmt den Rückstand in 500 ml Dichlormethan auf, wäscht die org. Phase fünfmal mit je 200 ml Wasser, einmal mit 200 ml ges. Kochsalzlösung und trocknet über Magnesiumsulfat. Der nach Entfernen des Lösungsmittels erhaltene Rückstand wird durch wiederholte Umkristallisation (z.B. aus Toluol, Aceton, Ethylacetat in Kombination mit Alkoholen wie Methanol, Ethanol, iso-Propanol etc.) und abschließende zweimalige fraktionierte Sublimation im Hochvakuum (p ca. $10^{-5}$ bis $10^{-6}$ mbar, T ca. 250 - 400°C) gereinigt.

**Beispiel B1:**

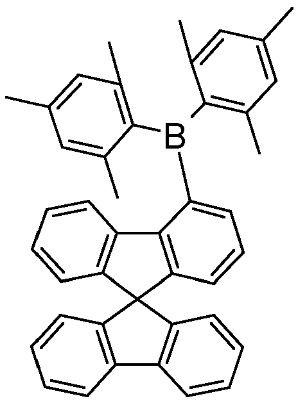

39.5 g (100 mmol) 4-Brom-spiro-9,9'-bifluoren, S1, 42.0 ml (105) mmol n-BuLi, 2.5 M in n-Hexan, 29.5 g (110 mmol) Fluor-di-mesitylboran [436-59-9]. Fünfmalige Umkristallisation aus Toluol / EtOH. Zweifache fraktionierte Sublimation, p ca. $10^{-5}$ mbar, T = 300 - 315 °C. Ausbeute: 19.2 g (34 mmol), 34 %. Reinheit: 99.9 % n. HPLC.

Analog können folgende Verbindungen dargestellt werden:

| Bsp. | Edukt | Produkt | Ausbeute |
|---|---|---|---|
| **1-Fluoren-Typ** | | | |
| B2 | 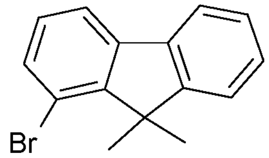 1225053-54-2 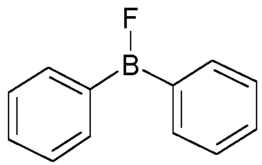 36140-35-9 | 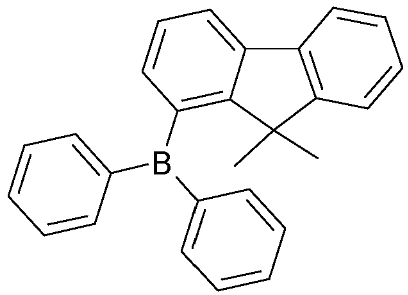 # | 22 % |
| **3-Fluoren-Typ** | | | |
| B3 | 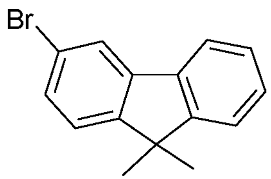 1190360-23-6 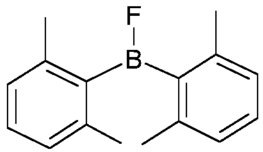 124855-14-7 | 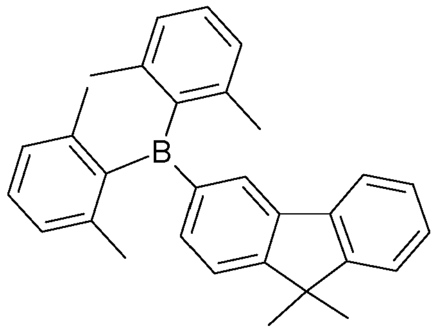 # | 35 % |

(fortgesetzt)

| 3-Fluoren-Typp | | | |
|---|---|---|---|
| B4 | 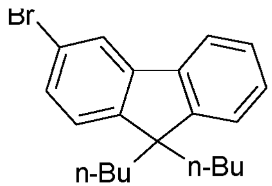 1246026-60-7 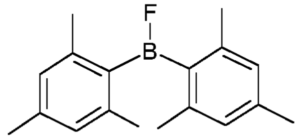 436-59-9 | 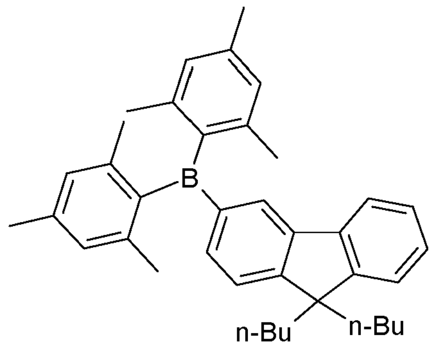 # | 30 % |
| B5 | 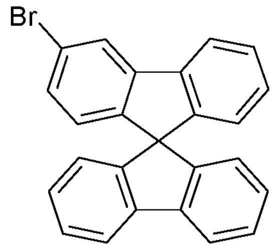 1361227-58-8 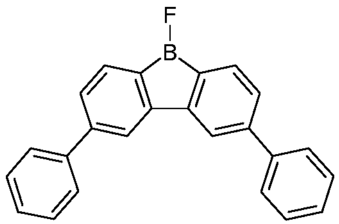 1361252-26-7 | 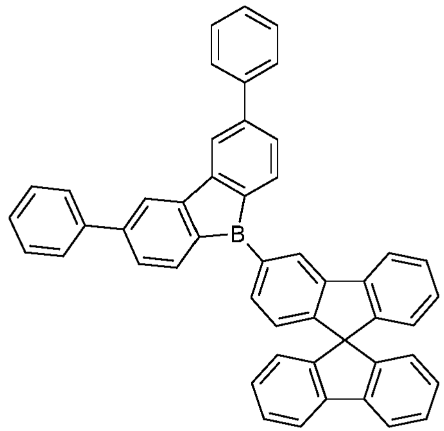 | 28 % |

(fortgesetzt)

| 3-Fluoren-Typp | | | |
|---|---|---|---|
| B6 | 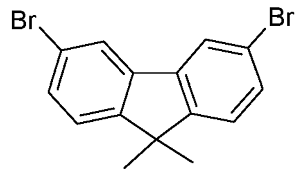 865702-19-8 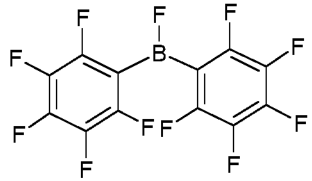 123168-21-8 | 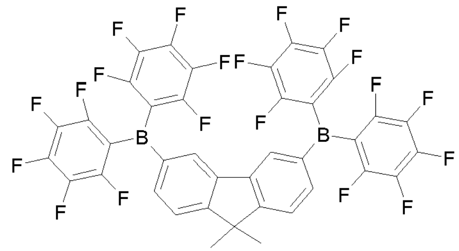 # | 18 % |
| B7 | 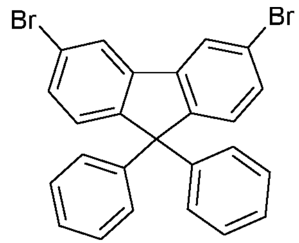 1319162-41-8 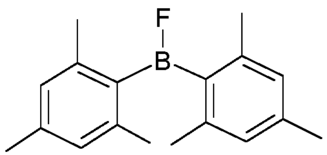 436-59-9 | 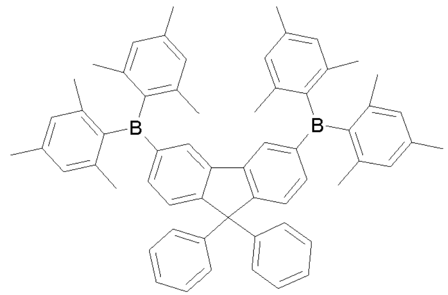 # | 36 % |

(fortgesetzt)

| 3-Fluoren-Typp | | | |
|---|---|---|---|
| B8 | 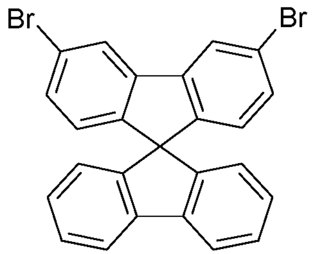 1373114-50-1 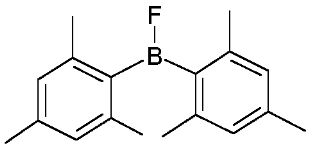 436-59-9 | 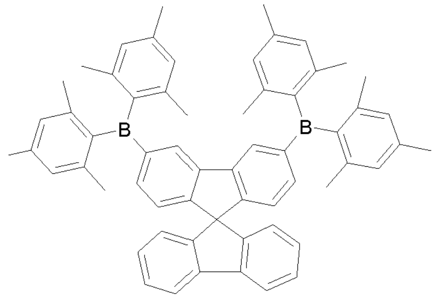 # | 34 % |
| B9 | 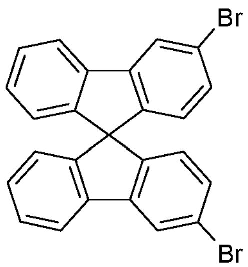 1418299-838 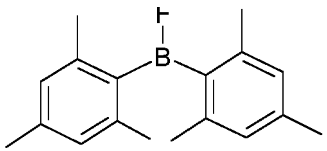 436-59-9 | 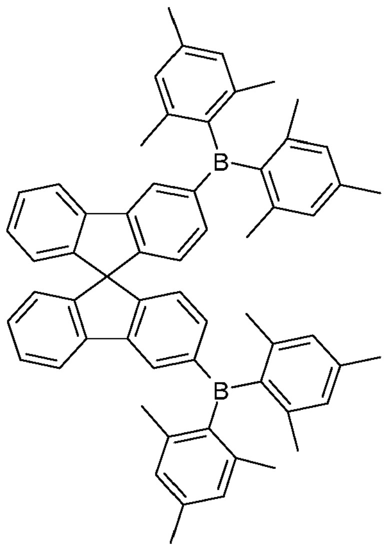 # | 31 % |

(fortgesetzt)

| 3-Fluoren-Typp | | | |
|---|---|---|---|
| B10 | 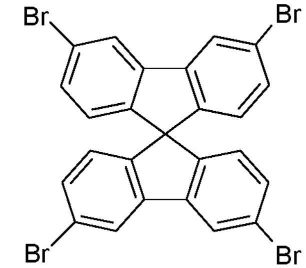 1374997-47-3 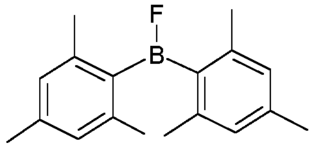 436-59-9 | 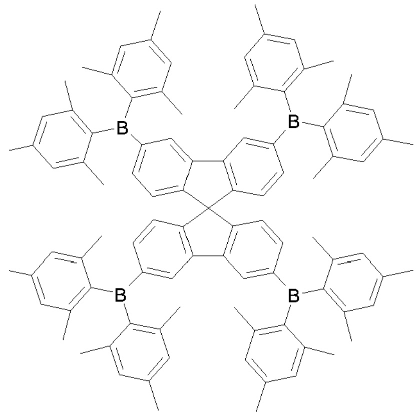 # | 29 % |
| B11 | 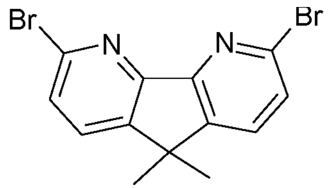 103679-39-1 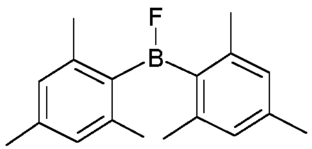 436-59-9 | 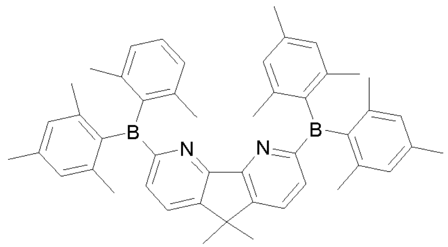 # | 32 % |

(fortgesetzt)

| | | | |
|---|---|---|---|
| **3-Fluoren-Typ** | | | |
| B12 | 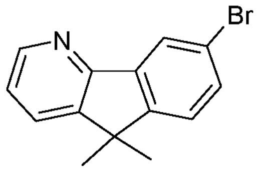 1033894-02-8 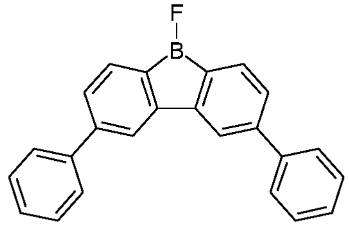 1361252-26-7 | 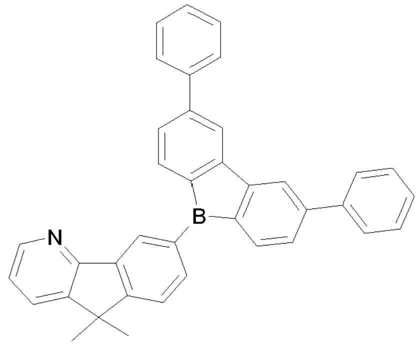 # | 25 % |
| **4-Fluoren-Typ** | | | |
| B13 | 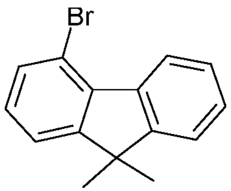 942615-32-9 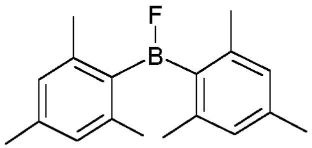 436-59-9 | 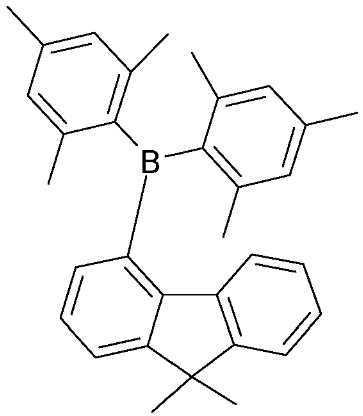 # | 27 % |

(fortgesetzt)

| 4-Fluoren-Typp | | | |
|---|---|---|---|
| B14 | 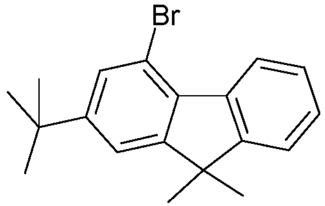 1013652-96-4 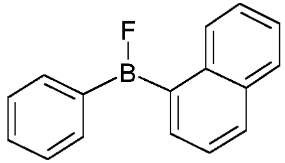 1361247-91-7 | 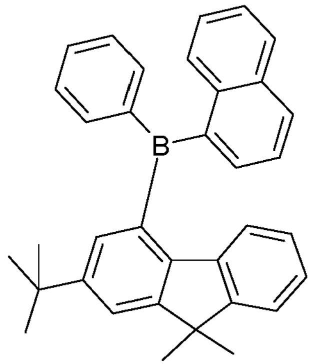 # | 24 % |
| B15 | 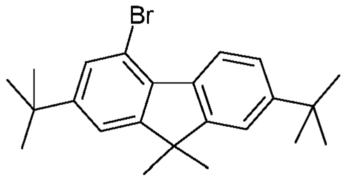 942615-28-3 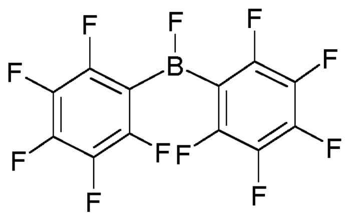 123168-21-8 | 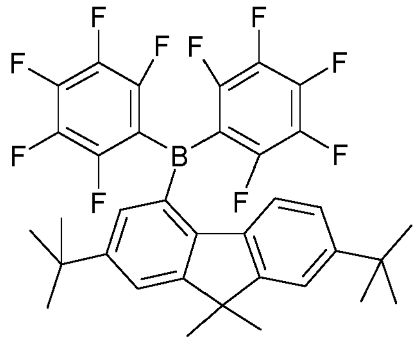 # | 23 % |

(fortgesetzt)

| 4-Fluoren-Typ | | | |
|---|---|---|---|
| B16 | 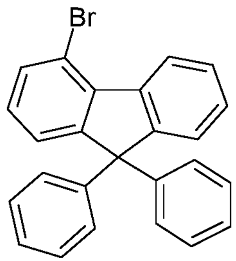 713125-22-5 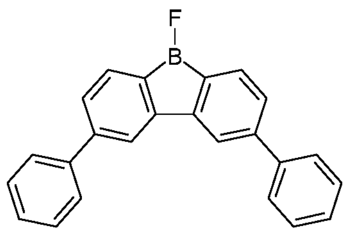 1361252-26-7 | 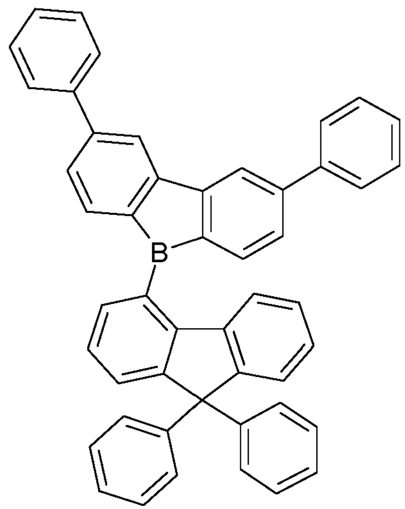 # | 25 % |
| B17 | 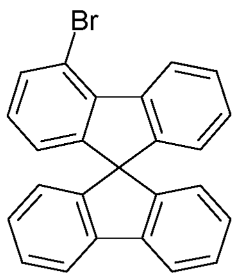 1161009-88-6 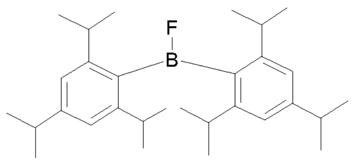 118513-79-4 | 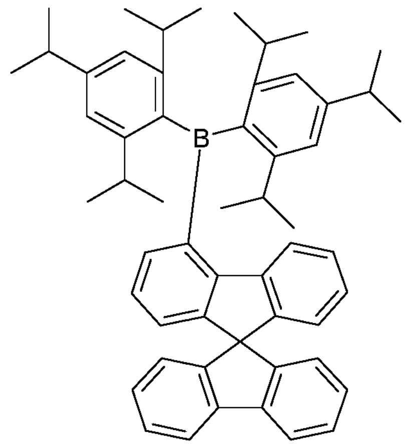 | 19 % |

(fortgesetzt)

| 4-Fluoren-Typp | | | |
|---|---|---|---|
| B18 | 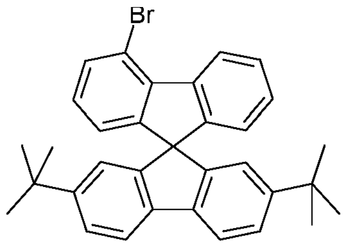 1365480-13-2 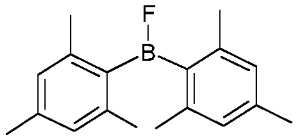 436-59-9 | 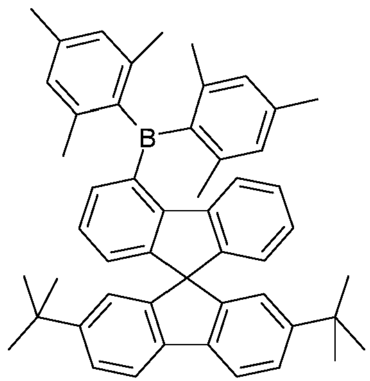 | 33 % |
| B19 | 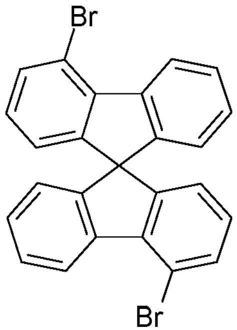 1257321-41-7 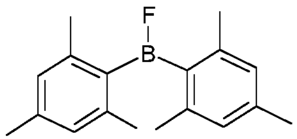 436-59-9 | 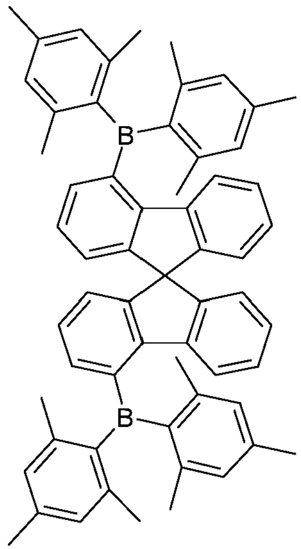 # | 29 % |

(fortgesetzt)

| | | | |
|---|---|---|---|
| **4-Fluoren-Typ** | | | |
| B20 | 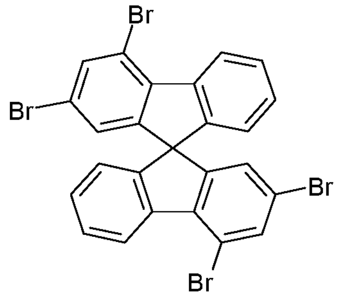 171408-83-6 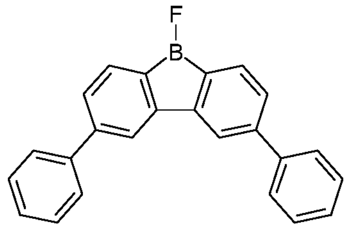 1361252-26-7 | 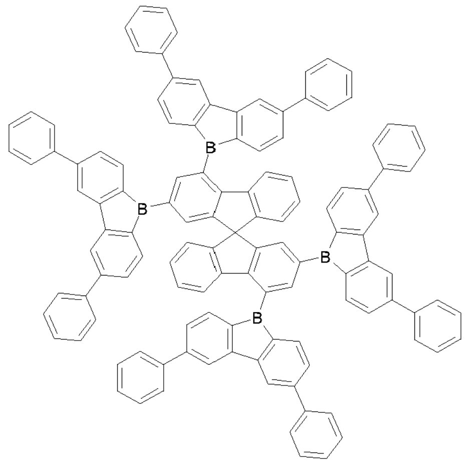 | 25 % |
| **2-Xanthen-Typ** | | | |
| B21 | 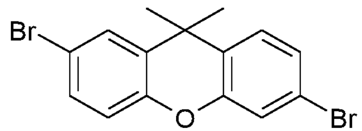 1246661-45-9 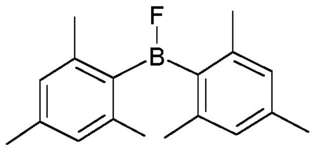 436-59-9 | 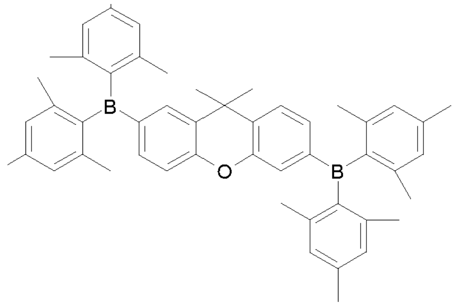 # | 36 % |

(fortgesetzt)

| 4-Xanthen-Typp | | | |
|---|---|---|---|
| B22 | 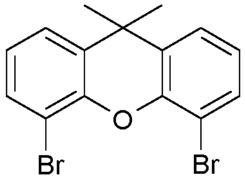 190789-35-6 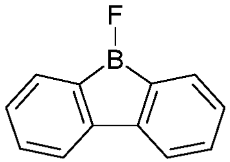 119615-28-0 | 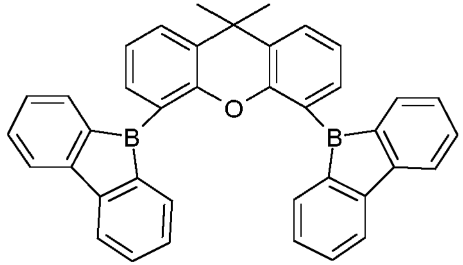 # | 21 % |
| B23 | 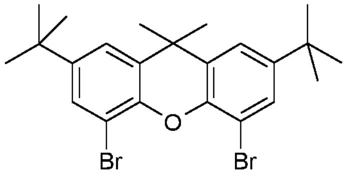 130252-43-8 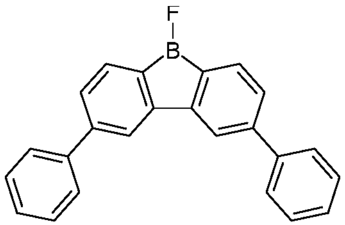 1361252-26-7 | 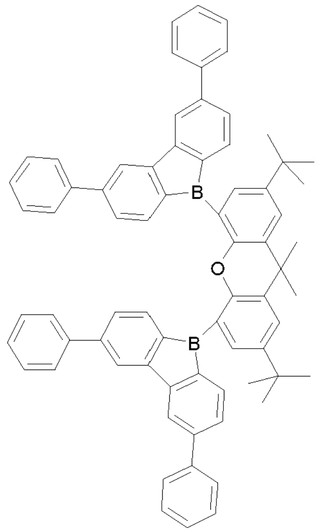 # | 23 % |

(fortgesetzt)

| 4-Xanthen-Typ | | | |
|---|---|---|---|
| B24 | 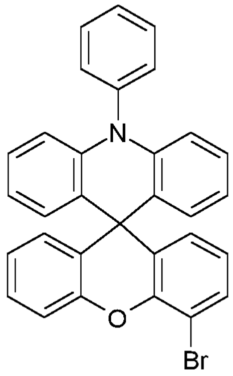 1443131-81-1 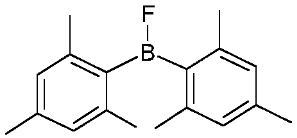 436-59-9 | 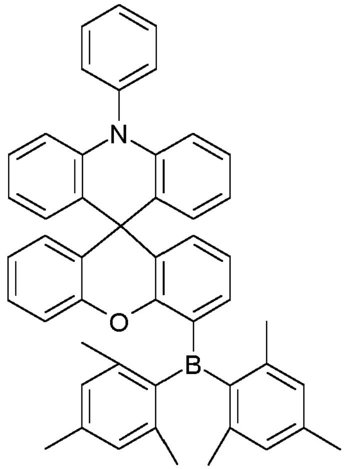 # | 35 % |
| # nicht erfindungsgemäß | | | |

**Variante2:**

Ein Gemisch aus 100 mmol des Bromids, 110 mmol der Boronsäure, 300 mmol Natriumhydrogencarbonat, 2 mmol S-Phos, 1 mmol Palladium(II)acetat, 300 ml Toluol, 200 ml Dioxan und 300 ml Wasser wird 16 h unter Rückfluss erhitzt. Nach Erkalten trennt man die wässrige Phase ab, wäscht die org. Phase dreimal mit je 300 ml Wasser, einmal mit 300 ml Kochsalzlösung, trocknet über Magnesiumsulfat und filtriert das Trockenmittel über ein Celite-Bett ab. Der nach Entfernen des Lösungsmittels erhaltene Rückstand wird durch wiederholte Umkristallisation (z.B. aus Toluol, Aceton, Ethylacetat in Kombination mit Alkoholen wie Methanol, Ethanol, iso-Propanol etc.) und abschließende zweimalige fraktionierte Sublimation im Hochvakuum (p ca. $10^{-5}$ bis $10^{-6}$ mbar, T ca. 250 - 400 °C) gereinigt.

**Beispiel B25:**

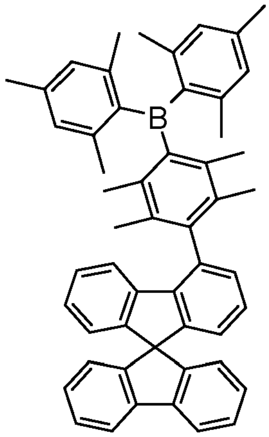

46.1 g (100 mmol) (4-Brom-2,3,5,6-tetramethylphenyl)bis(2,4,6-trimethylphenyl)boran [321735-74-4], 39.6 g (110 mmol) Spiro-9,9'-bifluoren-4-boronsäure [1421789-05-0], 25.2 g (300 mmol) Natriumhydrogencarbonat, 821 mg (2 mmol) S-Phos und 249 mg (1 mmol) Palladium(II)acetat. Fünfmalige Umkristallisation aus Toluol / EtOH. Zweifache fraktionierte Sublimation, p ca. $10^{-5}$ mbar, T = 330 - 340 °C. Ausbeute: 20.2 g (29 mmol), 29 %. Reinheit: 99.9% n. HPLC.

Analog können folgende Verbindungen dargestellt werden:

| Bsp. | Edukt | Produkt | Ausbeute |
|---|---|---|---|
| **1-Fluoren-Typ** | | | |
| B26 | 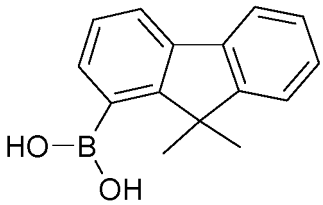 1251825-71-4 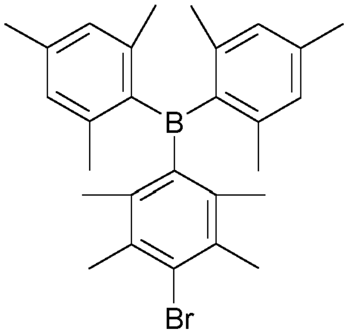 321735-74-4 | 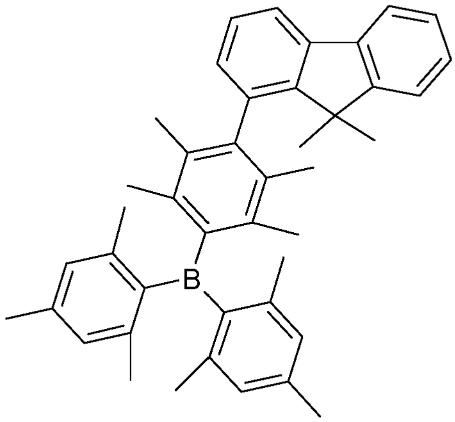 # | 23 % |
| B27 | 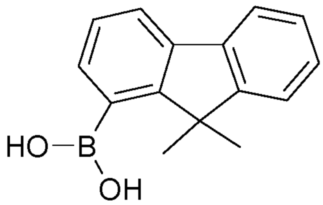 1251773-34-8 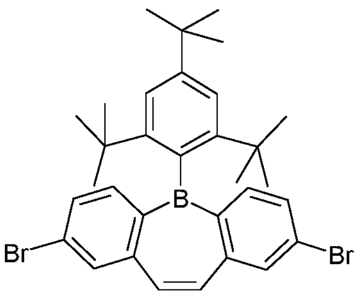 1279129-77-9 | 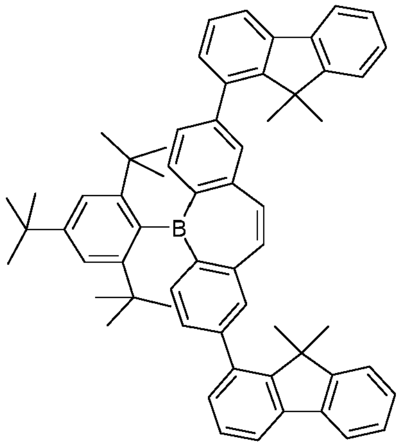 # | 19 % |

(fortgesetzt)

| Bsp. | Edukt | Produkt | Ausbeute |
|---|---|---|---|
| 1-Fluoren-Typ | | | |
| B28 | 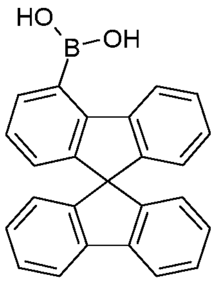 1421789-05-0 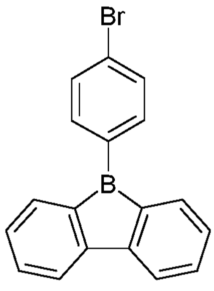 1299485-40-7 | 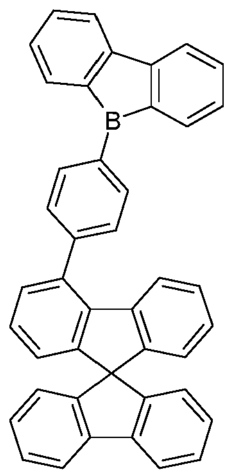 | 21 % |
| # nicht erfindungsgemäß | | | |

**Herstellung der OLEDs**

**1) Vakuum-prozessierte Devices:**

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (Indium Zinn Oxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Lochtransportschicht 3 (HTL3) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M3:M2:Ir-Dotand (55%:35%:10%) bedeutet hierbei, dass das Material M3 in einem Volumenanteil von 55%, M2 in einem Anteil von 35% und Ir-Dotand in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/$m^2$ in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/$m^2$ auf 500 cd/$m^2$. Je nach Emissionsfarbe wurden unterschiedliche Starthelligkeiten gewählt. Die Werte für die Lebensdauer können mit Hilfe dem

Fachmann bekannten Umrechnungsformeln auf eine Angabe für andere Startleuchtdichten umgerechnet werden. Hierbei ist die Lebensdauer für eine Startleuchtdichte von 1000 $cd/m^2$ eine übliche Angabe.

**Verwendung von erfindungsgemäßen Verbindungen OLEDs**

Die erfindungsgemäßen Verbindungen lassen sich unter anderem als TMM, ETM und HBM in fluoreszierenden und phosphoreszierenden OLEDs einsetzen.

Tabelle 1: Aufbau der OLED

| Bsp. | HTL2 Dicke | HTL3 Dicke | EML Dicke | HBL Dicke | ETL Dicke |
|---|---|---|---|---|---|
| **Verwendung als TMM** | | | | | |
| **Triplett Rot** | | | | | |
| D1 | HTM 240 nm | --- | B5:M2:Ir-R (60%:30%:10%) 30 nm | --- | ETM1:ETM2 (50%:50%) 20 nm |
| D2 | HTM 240 nm | --- | B24:Ir-R (95%:5%) 30 nm | --- | ETM1:ETM2 (50%:50%) 20 nm |
| **Triplett Grün** | | | | | |
| D3 | HTM 220 nm | --- | B1 :M2:Ir-G (65%:30%:5%) 25 nm | M1 10 nm | ETM1:ETM2 (50%:50%) 20 nm |
| D4 | HTM 220 nm | --- | B7:M2:Ir-G (65%:30%:5%) 25 nm | M1 10 nm | ETM1:ETM2 (50%:50%) 20 nm |
| D5 | HTM 220 nm | --- | B9:M2:Ir-G (65%:30%:5%) 25 nm | M1 10 nm | ETM1:ETM2 (50%:50%) 20 nm |
| D6 | HTM 220 nm | --- | B11 :M2:Ir-G (45%:45%:10%) 25 nm | M1 10 nm | ETM1:ETM2 (50%:50%) 20 nm |
| D7 | HTM 220 nm | --- | B18:M2:Ir-G (65%:30%:5%) 25 nm | M1 10 nm | ETM1:ETM2 (50%:50%) 20 nm |
| D8 | HTM 220 nm | --- | B21 :M2:Ir-G (50%:40%:10%) 25 nm | M1 10 nm | ETM1:ETM2 (50%:50%) 20 nm |
| D9 | HTM 220 nm | --- | B25:M2:Ir-G (50%:40%:10%) 25 nm | M1 10 nm | ETM1:ETM2 (50%:50%) 20 nm |
| D10 | HTM 220 nm | --- | B28:M2:Ir-G (60%:30%:10%) 25 nm | M1 10 nm | ETM1:ETM2 (50%:50%) 20 nm |
| Vgl.1 | HTM 220 nm | --- | Ref.1 :M2:Ir-G (60%:30%:10%) 25 nm | M1 10 nm | ETM1:ETM2 (50%:50%) 20 nm |
| **Triplett Blau** | | | | | |
| D11 | HTM 200 nm | EBM 10 nm | B8:M3:Ir-B (50%:40%:10%) 25 nm | M1 10 nm | ETM1:ETM2 (50%:50%) 20 nm |
| D12 | HTM 200 nm | EBM 10 nm | B19:M3:Ir-B (40%:50%:10%) 25 nm | M1 10 nm | ETM1:ETM2 (50%:50%) 20 nm |
| Vgl.2 | HTM 200 nm | EBM 10 nm | Ref.1 :M3:Ir-B (40%:50%:10%) 25 nm | M1 10 nm | ETM1:ETM2 (50%:50%) 20 nm |
| **Verwendung als ETM / HBM** | | | | | |
| **Triplett Grün** | | | | | |
| D13 | HTM 220 nm | --- | M1 :M2:Ir-G (65%:30%:5%) 25 nm | --- | B25 (100%) 30 nm / ETM2 2 nm |

(fortgesetzt)

| Verwendung als ETM / HBM | | | | | |
|---|---|---|---|---|---|
| Triplett Grün | | | | | |
| D14 | HTM 220 nm | --- | B16:M2:Ir-G (45%:45%:10%) 25 nm | B16 10 nm | B23 (100%) 20 nm / ETM2 2 nm |
| Singulett Blau | | | | | |
| D15 | HTM 190 nm | --- | SMB:SEB (95%:5%) 25 nm | --- | B11 (100%) 20 nm / ETM2 2 nm |
| D16 | HTM 190 nm | --- | SMB:SEB (95%:5%) 25 nm | --- | B14 (100%) 20 nm / ETM2 2 nm |
| Vgl.3 | HTM 190 nm | --- | SMB:SEB (95%:5%) 25 nm | --- | Ref.2 (100%) 20 nm / ETM2 2 nm |

Tabelle 2: Ergebnisse der Vakuum-prozessierten OLEDs

| Bsp. | EQE (%) 1000 $cd/m^2$ | Spannung (V) 1000 $cd/m^2$ | CIE x/y 1000 $cd/m^2$ | LD50 (h) 1000 $cd/m^2$ |
|---|---|---|---|---|
| Verwendung als TMM | | | | |
| Triplett Rot | | | | |
| D1 | 13.7 | 3.7 | 0.66/0.33 | --- |
| D2 | 14.3 | 3.2 | 0.66/0.33 | 85000 |
| Triplett Grün | | | | |
| D3 | 19.0 | 4.0 | 0.34/0.63 | --- |
| D4 | 18.7 | 4.0 | 0.35/0.62 | --- |
| D5 | 18.8 | 4.2 | 0.34/0.63 | --- |
| D6 | 20.4 | 3.3 | 0.35/0.63 | 70000 |
| D7 | 18.3 | 4.2 | 0.35/0.62 | --- |
| D8 | 18.5 | 4.1 | 0.35/0.62 | --- |
| D9 | 19.3 | 4.3 | 0.35/0.64 | --- |
| D10 | 18.8 | 4.0 | 0.34/0.62 | 55000 |
| Vgl.1 | 16.6 | 4.4 | 0.34/0.63 | 35000 |
| Triplett Blau | | | | |
| D11 | 12.5 | 3.8 | 0.15/0.31 | --- |
| D12 | 13.2 | 4.0 | 0.15/0.30 | --- |
| Vgl.2 | 10.4 | 4.0 | 0.15/0.33 | --- |
| Verwendung als ETM / HBM | | | | |
| Triplett Grün | | | | |
| D13 | 19.3 | 3.6 | 0.34/0.62 | 45000 |
| D14 | 20.1 | 3.7 | 0.35/0.62 | - |
| Singulett Blau | | | | |
| D15 | 8.5 | 4.0 | 0.15/0.17 | - |
| D16 | 8.1 | 4.8 | 0.15/0.17 | 12000 |
| Vgl.3 | 7.2 | 4.3 | 0.15/0.17 | 7500 |

**2) Lösungs-prozessierte Devices:**

**A: Aus löslichen Funktionsmaterialien**

Die erfindungsgemäßen Verbindungen können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z.B. in der WO 2004/037887).

Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices enthalten eine Emissionsschicht aus (Polystyrol):Matrixl :Matrix2:Ir-G-Sol (25%:35%:20%:20%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x $10^{-6}$ mbar) aufgedampft. Optional kann zunächst eine Lockblockierschicht und dann eine Eletronentransportschicht und dann erst die Kathode (z.B. Al oder LiF/Al) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

Tabelle 3: Ergebnisse mit aus Lösun prozessierten Materialien

| Bsp. | Matrix1 Matrix2 | EQE (%) 1000 cd/m$^2$ | Spannung (V) 1000 cd/m$^2$ | CIE x/y 1000 cd/m$^2$ |
|---|---|---|---|---|
| Grüne OLEDs | | | | |
| D-Sol1 | B10<br>M4 | 17.8 | 5.8 | 0.34/0.64 |
| D-Sol1 | B20<br>M4 | 18.5 | 5.6 | 0.35/0.63 |

Tabelle 4: Strukturformeln der verwendeten Materialien

| | |
|---|---|
| 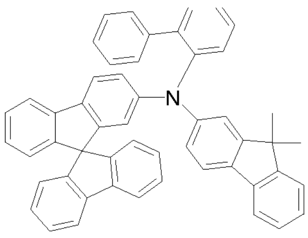 | 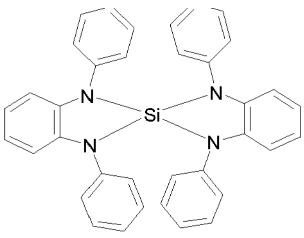 |
| HTM | EBM |

(fortgesetzt)

| | |
|---|---|
| 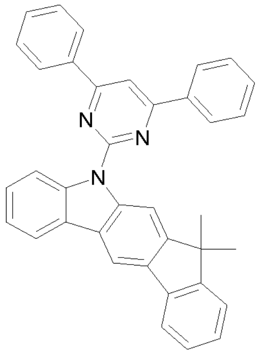 | 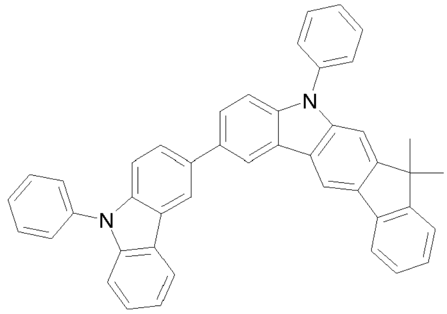 |
| M1 | M2 |
| 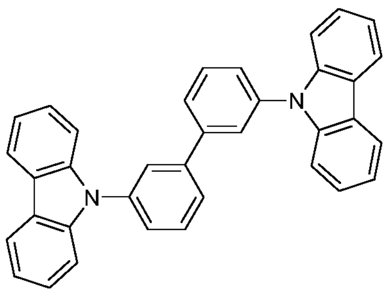 | 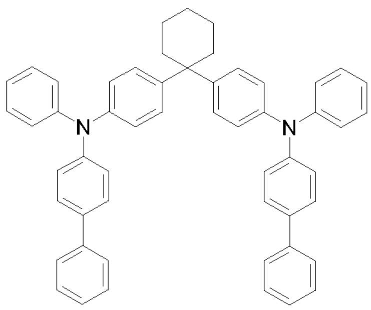 |
| M3 | M4 |
| 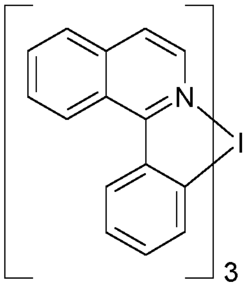 | 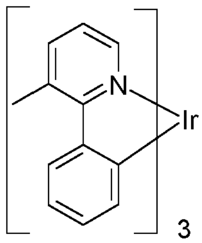 |
| Ir-R | Ir-G |
| 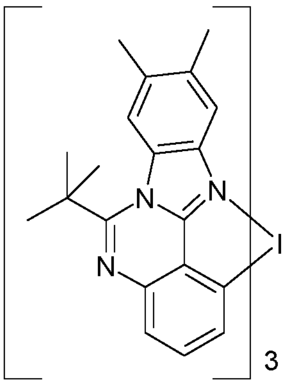 | 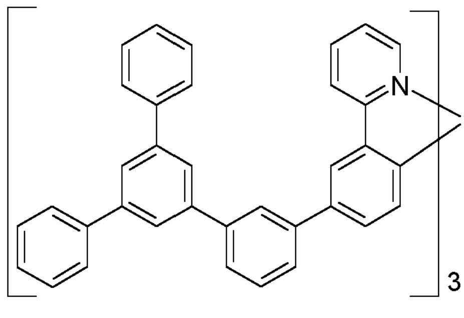 |
| Ir-B | Ir-G-Sol |

(fortgesetzt)

| | |
|---|---|
| 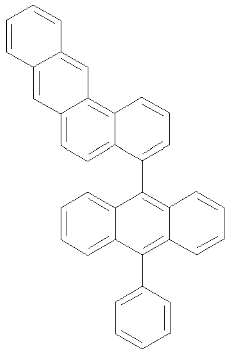 | 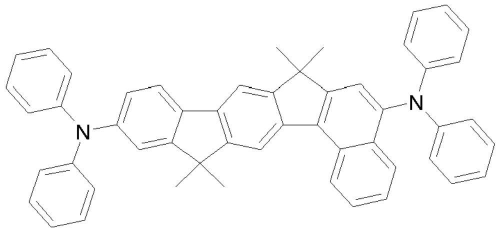 |
| SBM | SEB |
| 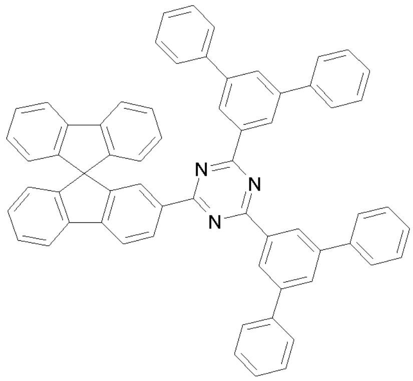 | 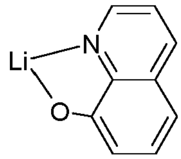 |
| ETM1 | ETM2 |
| 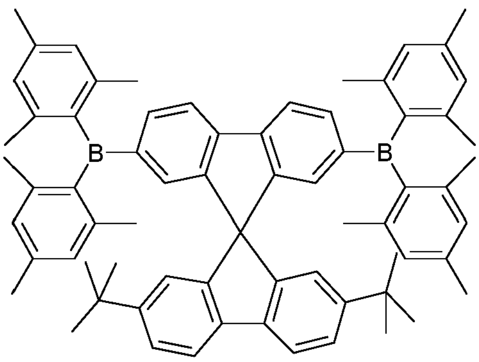 EP 1 345948 B1 | 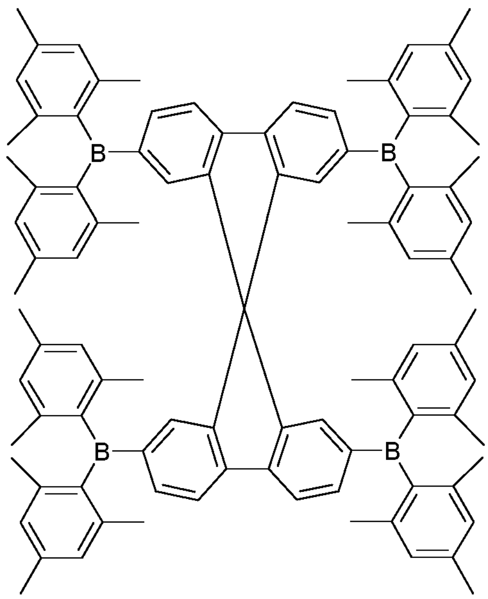 EP 1 345948 B1 |
| Ref.1 | Ref.2 |

**Bestimmung der HOMO/LUMO Lagen und des Triplett-Niveaus**

Das Triplett-Niveau $T_1$ der Verbindungen wird über quantenchemische Rechnungen bestimmt. Hierzu wird das Programmpaket "Gaussian03W" (Gaussian Inc.) verwendet. Zur Berechnung organischer Substanzen wird zuerst eine Geometrieoptimierung mit der Methode "Ground State/Semiempirical/ Default Spin/AM1" (Charge 0/Spin Singlet) durchgeführt. Im Anschluss erfolgt auf Grundlage der optimierten Geometrie eine Energierechnung. Hierbei wird die Methode "TD-SCF/DFT/ Default Spin/B3PW91" mit dem Basissatz "6-31 G(d)" verwendet (Charge 0/Spin Singlet). Aus der Energierechnung erhält man die Energie des T1-Zustandes in eV, die für die beiden Verb. Ref.1 und Bsp. 18 in Tabelle 1 angegeben sind.

Tabelle 1: Berechnete Triplet-Energie

| Substanz | Triplet-Energie [eV] |
|---|---|
| Ref.1 aus EP 1 345948 B1 | 2.56 |
| | |
| 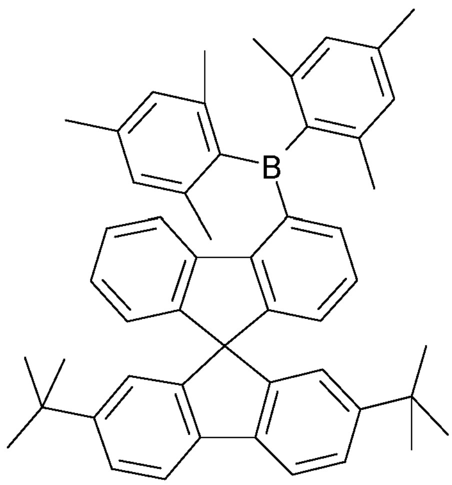 | 2.80 |
| B 18 | |

Die Daten zeigen, dass das Triplettniveau überraschend durch die erfindungsgemäßen Maßnahmen im Vergleich zum Stand der Technik gesteigert werden kann.

**Patentansprüche**

1. Borenthaltende Verbindung umfassend mindestens eine Struktur der Formeln (V-5), (V-6), (V-7), (V-8), (V-9) und/oder (V-10)

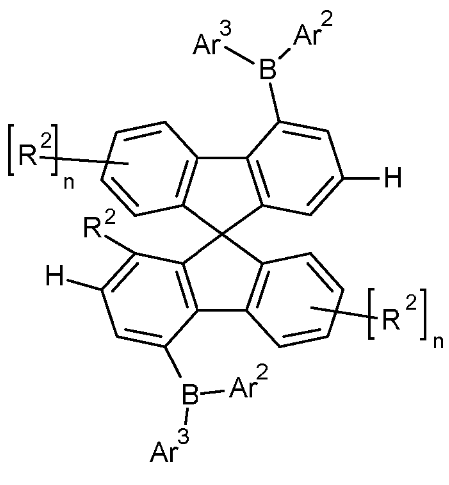

Formel (V-5)

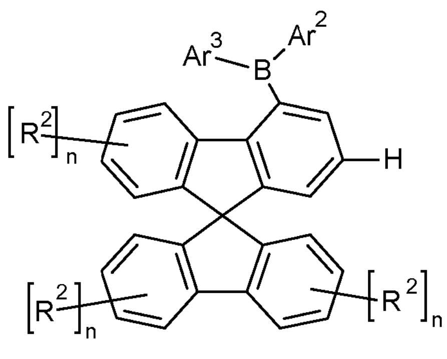

Formel (V-6)

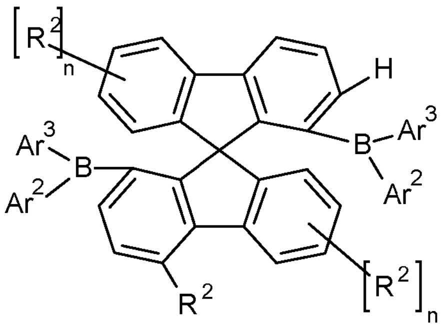

Formel (V-7)

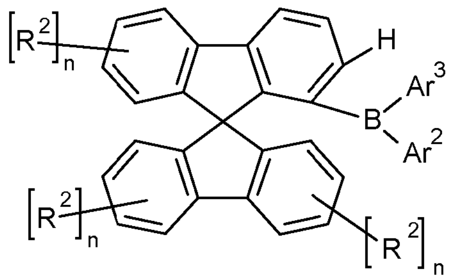

Formel (V-8)

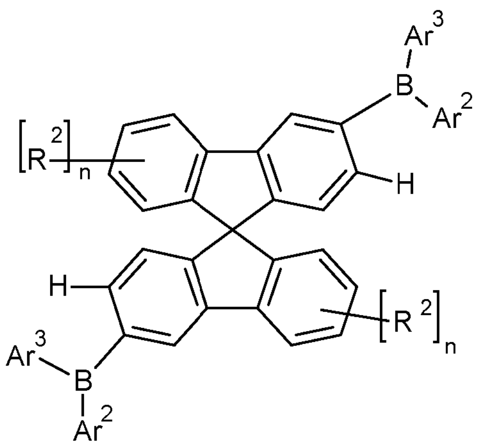

Formel (V-9)

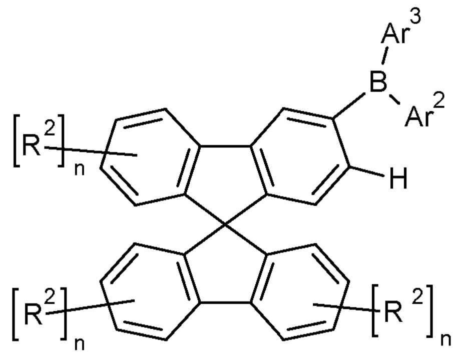

Formel (V-10)

wobei für die verwendeten Symbole gilt:

n ist bei jedem Auftreten gleich oder verschieden 0 oder 1 bedeutet

$R^2$, $R^3$ ist bei jedem Auftreten gleich oder verschieden H, D, F, Cl, Br, I, CHO, $C(=O)Ar^1$, $P(=O)(Ar^1)_2$, $S(=O)Ar^1$, $S(=O)_2Ar^1$, CN, $NO_2$, $Si(R^4)_3$, $B(OR^4)_2$, $OSO_2R^4$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten $R^4$ substituiert sein kann, wobei eine oder mehrere nicht benachbarte $CH_2$-Gruppen durch $R^4C=CR^4$, C=C , $Si(R^4)_2$, $Ge(R^4)_2$, $Sn(R^4)_2$, C=O, C=S, C=Se, $P(=O)(R^4)$, SO, $SO_2$, O, S oder $CONR^4$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 40 aromatischen Ringatomen, das jeweils durch einen oder mehrere Reste $R^4$ substituiert sein kann, oder eine Aryloxy- oder Heteroaryloxygruppe mit 5 bis 40 aromatischen Ringatomen, die durch einen oder mehrere Reste $R^4$ substituiert sein kann, oder eine Kombination dieser Systeme; dabei können zwei oder mehrere benachbarte Substituenten $R^2$ oder $R^3$ auch miteinander ein mono- oder polycyclisches, aliphatisches oder aromatisches Ringsystem bilden;

$R^4$ ist bei jedem Auftreten gleich oder verschieden H, D, F, Cl, Br, I, CHO, $C(=O)Ar^1$, $P(=O)(Ar^1)_2$, $S(=O)Ar^1$, $S(=O)_2Ar^1$, CN, $NO_2$, $Si(R^5)_3$, $B(OR^5)_2$, $OSO_2R^5$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten $R^5$ substituiert sein kann, wobei eine oder mehrere nicht benachbarte $CH_2$-Gruppen durch C=C , $Si(R^5)_2$, $Ge(R^5)_2$, $Sn(R^5)_2$, C=O, C=S, C=Se, $P(=O)(R^5)$, SO, $SO_2$, O, S oder $CONR^5$ ersetzt sein können und wobei ein oder mehrere H-Atome durch D, F, Cl, Br, I, CN oder $NO_2$ ersetzt sein können, oder eine Kombination dieser Systeme;

$Ar^1$ ist bei jedem Auftreten gleich oder verschieden ein aromatisches oder heteroaromatisches Ringsystem mit 5 bis 30 aromatischen Ringatomen, das mit einem oder mehreren Resten $R^3$ substituiert sein kann;

$R^5$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch H-Atome durch F ersetzt sein können; dabei können zwei oder mehrere benachbarte Substituenten $R^5$ auch miteinander ein mono- oder polycyclisches, aliphatisches oder aromatisches Ringsystem bilden;
$Ar^2$, $Ar^3$ ist bei jedem Auftreten gleich oder verschieden ein aromatisches oder heteroaromatisches Ringsystem mit 5 bis 30 aromatischen Ringatomen, das mit einem oder mehreren Resten $R^3$ substituiert sein kann; dabei können auch die Reste $Ar^2$ und $Ar^3$ durch eine Einfachbindung oder eine Brücke, ausgewählt aus $B(R^5)$, $C(R^5)_2$, $Si(R^5)_2$, C=O, $C=NR^5$, $C=C(R^5)_2$, O, S, S=O, $SO_2$, $N(R^5)$, $P(R^5)$ und $P(=O)R^5$, miteinander verknüpft sein;
$Ar^4$ ist bei jedem Auftreten gleich oder verschieden eine Arylgruppe mit 6 bis 40 C-Atomen oder eine Heteroarylgruppe mit 3 bis 40 C-Atomen, welche jeweils durch einen oder mehrere Reste $R^3$ substituiert sein kann.

2. Verbindung gemäß Anspruch 1, **dadurch gekennzeichnet, dass** die Reste $Ar^2$ und $Ar^3$ eine Arylgruppe mit 6 Kohlenstoffatomen darstellen, die mit bis zu drei Resten $R^3$ substituiert sein kann; dabei können auch die Reste $Ar^2$ und $Ar^3$ durch eine Einfachbindung oder eine Brücke, ausgewählt aus $B(R^5)$, $C(R^5)_2$, $Si(R^5)_2$, C=O, $C=NR^5$, $C=C(R^5)_2$, O, S, S=O, $SO_2$, $N(R^5)$, $P(R^5)$ und $P(=O)R^5$, miteinander verknüpft sein.

3. Zusammensetzung enthaltend wenigstens eine Verbindung gemäß Anspruch 1 oder 2 sowie wenigstens eine weitere Verbindung ausgewählt aus der Gruppe bestehend aus fluoreszierenden Emittern, phosphoreszierenden Emittern, Host Materialien, Matrix-Materialien, Elektronentransportmaterialien, Elektroneninjektionsmaterialien, Lochleitermaterialien, Lochinjektionsmaterialien, Elektronenblockiermaterialien und Lochblockiermaterialien.

4. Formulierung enthaltend wenigstens eine Verbindung gemäß Anspruch 1 oder 2 oder wenigstens eine Zusammensetzung gemäß Anspruch 3 sowie wenigstens ein Lösungsmittel.

5. Verfahren zur Herstellung einer Verbindung gemäß Anspruch 1 oder 2 durch Umsetzung mindestens einer Aryllithium-Verbindung mit mindestens einem Halogenboran und/oder mindestens einem Borinsäureester.

6. Verwendung einer Verbindung gemäß Anspruch 1 oder 2 in einer elektronischen Vorrichtung als Lochblockiermaterial, Elektroneninjektionsmaterial, und/oder Elektronentransportmaterial.

7. Elektronische Vorrichtung, enthaltend mindestens eine borenthaltende Verbindung gemäß Anspruch 1 oder 2 oder eine Zusammensetzung gemäß Anspruch 3, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laser-dioden.

## Claims

1. Boron-containing compound encompassing at least one structure of the formulae (V-5), (V-6), (V-7), (V-8), (V-9) and/or (V-10)

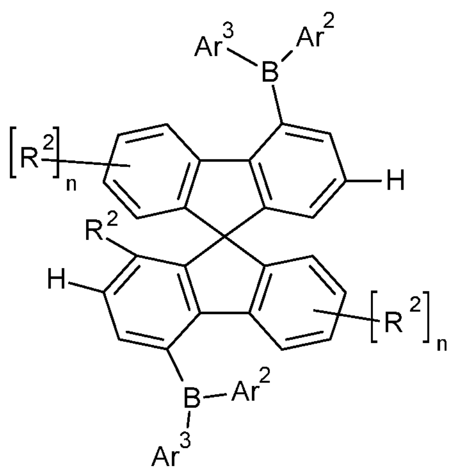

formula (V-5)

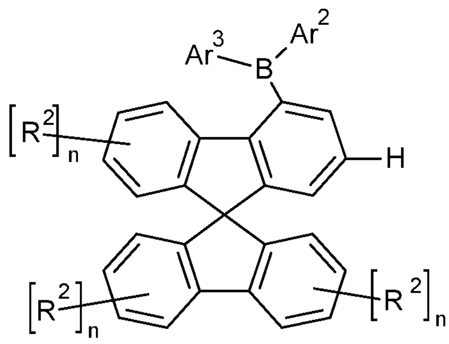

formula (V-6)

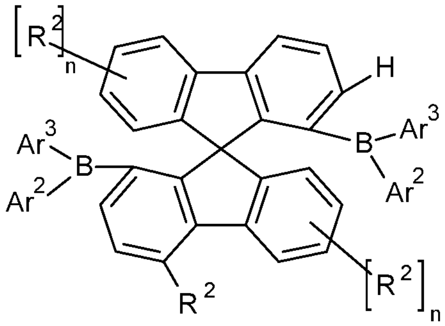

formula (V-7)

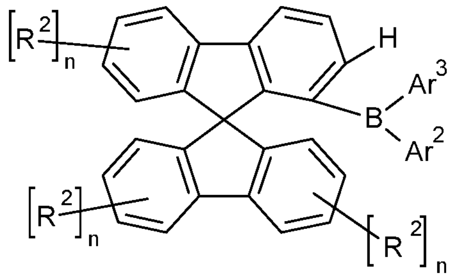

formula (V-8)

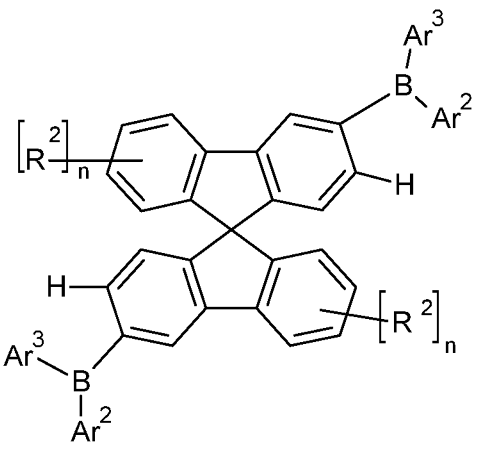

formula (V-9)

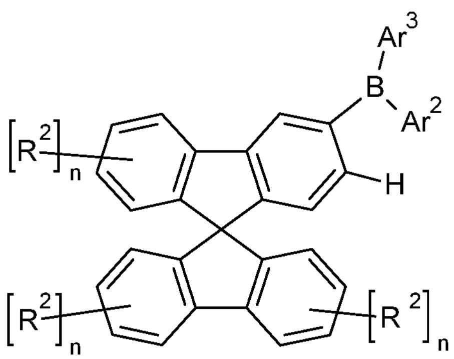

formula (V-10)

where the following applies to the symbols used:

n is on each occurrence, identically or differently, 0 or 1;

$R^2$ , $R^3$ are on each occurrence, identically or differently, H, D, F, Cl, Br, I, CHO, $C(=O)Ar^1$, $P(=O)(Ar^1)_2$, $S(=O)Ar^1$, $S(=O)_2Ar^1$, CN, $NO_2$, $Si(R^4)_3$, $B(OR^4)_2$, $OSO_2R^4$, a straight-chain alkyl, alkoxy or thioalkoxy group having 1 to 40 C atoms or a branched or cyclic alkyl, alkoxy or thioalkoxy group having 3 to 40 C atoms, which may in each

case be substituted by one or more radicals $R^4$, where one or more non-adjacent $CH_2$ groups may be replaced by $R^4C=CR^4$, C=C , $Si(R^4)_2$, $Ge(R^4)_2$, $Sn(R^4)_2$, C=O, C=S, C=Se, $P(=O)(R^4)$, SO, $SO_2$, 0, S or $CONR^4$ and where one or more H atoms may be replaced by D, F, Cl, Br, I, CN or $NO_2$, or an aromatic or heteroaromatic ring system having 5 to 40 aromatic ring atoms, which may in each case be substituted by one or more radicals $R^4$, or an aryloxy or heteroaryloxy group having 5 to 40 aromatic ring atoms, which may be substituted by one or more radicals $R^4$, or a combination of these systems; two or more adjacent substituents $R^2$ or $R^3$ may also form a mono- or polycyclic, aliphatic or aromatic ring system with one another;

$R^4$ is on each occurrence, identically or differently, H, D, F, Cl, Br, I, CHO, $C(=O)Ar^1$, $P(=O)(Ar^1)_2$, $S(=O)Ar^1$, $S(=O)_2Ar^1$, CN, $NO_2$, $Si(R^5)_3$, $B(OR^5)_2$, $OSO_2R^5$, a straight-chain alkyl, alkoxy or thioalkoxy group having 1 to 40 C atoms or a branched or cyclic alkyl, alkoxy or thioalkoxy group having 3 to 40 C atoms, which may in each case be substituted by one or more radicals $R^5$, where one or more non-adjacent $CH_2$ groups may be replaced by C=C , $Si(R^5)_2$, $Ge(R^5)_2$, $Sn(R^5)_2$, C=O, C=S, C=Se, $P(=O)(R^5)$, SO, $SO_2$, 0, S or $CONR^5$ and where one or more H atoms may be replaced by D, F, Cl, Br, I, CN or $NO_2$, or a combination of these systems;

$Ar^1$ is on each occurrence, identically or differently, an aromatic or heteroaromatic ring system having 5 to 30 aromatic ring atoms, which may be substituted by one or more radicals $R^3$;

$R^5$ is on each occurrence, identically or differently, H, D, F or an aliphatic, aromatic and/or heteroaromatic hydrocarbon radical having 1 to 20 C atoms, in which H atoms may also be replaced by F; two or more adjacent substituents $R^5$ may also form a mono-or polycyclic, aliphatic or aromatic ring system with one another;

$Ar^2$, $Ar^3$ are on each occurrence, identically or differently, an aromatic or heteroaromatic ring system having 5 to 30 aromatic ring atoms, which may be substituted by one or more radicals $R^3$; the radicals $Ar^2$ and $Ar^3$ may also be linked to one another by a single bond or a bridge selected from $B(R^5)$, $C(R^5)_2$, $Si(R^5)_2$, C=O, $C=NR^5$, $C=C(R^5)_2$, O, S, S=O, $SO_2$, $N(R^5)$, $P(R^5)$ and $P(=O)R^5$;

$Ar^4$ is on each occurrence, identically or differently, an aryl group having 6 to 40 C atoms or a heteroaryl group having 3 to 40 C atoms, which may in each case be substituted by one or more radicals $R^3$.

2. Compound according to Claim 1, **characterised in that** the radicals $Ar^2$ and $Ar^3$ represent an aryl group having 6 carbon atoms, which may be substituted by up to three radicals $R^3$; the radicals $Ar^2$ and $Ar^3$ may also be linked to one another by a single bond or a bridge selected from $B(R^5)$, $C(R^5)_2$, $Si(R^5)_2$, C=O, $C=NR^5$, $C=C(R^5)_2$, 0, S, S=O, $SO_2$, $N(R^5)$, $P(R^5)$ and $P(=O)R^5$.

3. Composition comprising at least one compound according to Claim 1 or 2 and at least one further compound selected from the group consisting of fluorescent emitters, phosphorescent emitters, host materials, matrix materials, electron-transport materials, electron-injection materials, hole-conductor materials, hole-injection materials, electronblocking materials and hole-blocking materials.

4. Formulation comprising at least one compound according to Claim 1 or 2 or at least one composition according to Claim 3 and at least one solvent.

5. Process for the preparation of a compound according to Claim 1 or 2 by reaction of at least one aryllithium compound with at least one boron halide and/or at least one borinic acid ester.

6. Use of a compound according to Claim 1 or 2 in an electronic device as hole-blocking material, electron-injection material and/or electron-transport material .

7. Electronic device containing at least one boron-containing compound according to Claim 1 or 2 or a composition according to Claim 3, where the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

## Revendications

1. Composé contenant du bore comprenant au moins une structure des formules (V-5), (V-6), (V-7), (V-8), (V-9) et/ou (V-10)

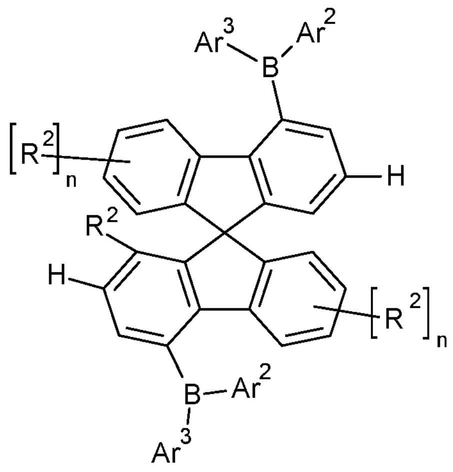

formule (V-5)

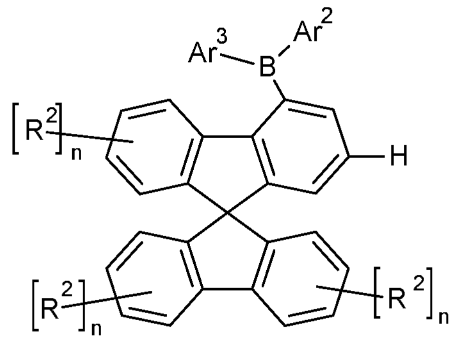

formule (V-6)

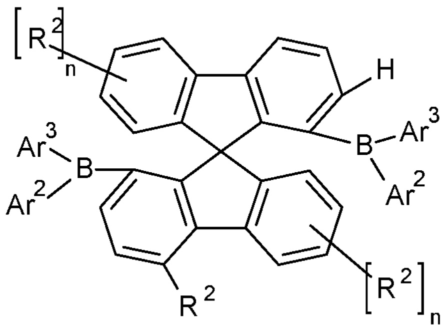

formule (V-7)

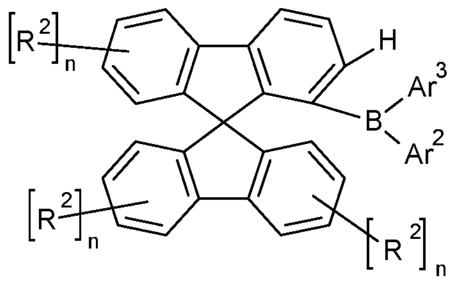

formule (V-8)

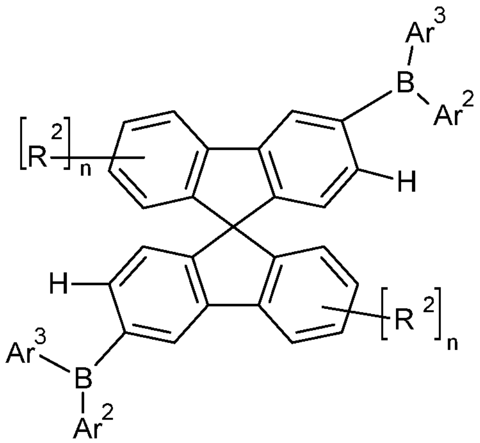

formule (V-9)

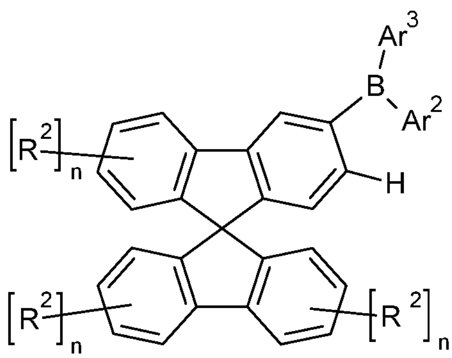

formule (V-10)

dans lesquelles ce qui suit s'applique aux symboles qui sont utilisés :

n est pour chaque occurrence, de manière identique ou différente, 0 ou 1 ;

$R^2$, $R^3$ sont pour chaque occurrence, de manière identique ou différente, H, D, F, CL, Br, I, CHO, $C(=O)Ar^1$, $P(=O)(Ar^1)_2$, $S(=O)Ar^1$, $S(=O)_2Ar^1$, CN, $NO_2$, $Si(R^4)_3$, $B(OR^4)_2$, $OSO_2R^4$, un groupe alkyle, alcoxy ou thioalcoxy en chaîne droite qui comporte de 1 à 40 atome(s) de C ou un groupe alkyle, alcoxy ou thioalcoxy ramifié ou

cyclique qui comporte de 3 à 40 atomes de C, lequel peut dans chaque cas être substitué par un radical ou par plusieurs radicaux $R^4$, où un ou plusieurs groupe(s) $CH_2$ non adjacents peut/peuvent être remplacé(s) par $R^4C=CR^4$, C=C , $Si(R^4)_2$, $Ge(R^4)_2$, $Sn(R^4)_2$, C=O, C=S, C=Se, $P(=O)(R^4)$, SO, $SO_2$, 0, S ou $CONR^4$ et où un ou plusieurs atome(s) de H peut/peuvent être remplacé(s) par D, F, Cl, Br, I, CN ou $NO_2$, ou un système de cycle aromatique ou hétéroaromatique qui comporte de 5 à 40 atomes de cycle aromatique, lequel peut dans chaque cas être substitué par un radical ou par plusieurs radicaux $R^4$, ou un groupe aryloxy ou hétéroaryloxy qui comporte de 5 à 40 atomes de cycle aromatique, lequel peut être substitué par un radical ou par plusieurs radicaux $R^4$, ou une combinaison de ces systèmes ; deux substituants $R^2$ ou $R^3$ adjacents ou plus peuvent également former un système de cycle aliphatique ou aromatique mono- ou polycyclique l'un avec l'autre ou les uns avec les autres ;

$R^4$ est pour chaque occurrence, de manière identique ou différente, H, D, F, Cl, Br, I, CHO, $C(=O)Ar^1$, $P(=O)(Ar^1)_2$, $S(=O)Ar^1$, $S(=O)_2Ar^1$, CN, $NO_2$, $Si(R^5)_3$, $B(OR^5)_2$, $OSO_2R^5$, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C, lequel peut dans chaque cas être substitué par un radical ou par plusieurs radicaux $R^5$, où un ou plusieurs groupe(s) $CH_2$ non adjacents peut/peuvent être remplacé(s) par C=C , $Si(R^5)_2$, $Ge(R^5)_2$, $Sn(R^5)_2$, C=O, C=S, C=Se, $P(=O)(R^5)$, SO, $SO_2$, 0, S ou $CONR^5$ et où un ou plusieurs atome(s) de H peut/peuvent être remplacé(s) par D, F, Cl, Br, I, CN ou $NO_2$, ou une combinaison de ces systèmes ;

$Ar^1$ est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux $R^3$ ;

$R^5$ est pour chaque occurrence, de manière identique ou différente, H, D, F ou un radical hydrocarbone aliphatique, aromatique et/ou hétéroaromatique qui comporte de 1 à 20 atome(s) de C, où les atomes de H peuvent également être remplacés par F ; deux substituants $R^5$ adjacents ou plus peuvent également former un système de cycle aliphatique ou aromatique mono- ou polycyclique l'un avec l'autre ou les uns avec les autres ;

$Ar^2$, $Ar^3$ sont pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux $R^3$; les radicaux $Ar^2$ et $Ar^3$ peuvent également être liés l'un à l'autre par une liaison simple ou par un pont qui est sélectionné parmi $B(R^5)$, $C(R^5)_2$, $Si(R^5)_2$, C=O, $C=NR^5$, $C=C(R^5)_2$, 0, S, S=O, $SO_2$, $N(R^5)$, $P(R^5)$ et $P(=O)R^5$ ;

$Ar^4$ est pour chaque occurrence, de manière identique ou différente, un groupe aryle qui comporte de 6 à 40 atomes de C ou un groupe hétéroaryle qui comporte de 3 à 40 atomes de C, lequel peut dans chaque cas être substitué par un radical ou par plusieurs radicaux $R^3$.

2. Composé selon la revendication 1, **caractérisé en ce que** les radicaux $Ar^2$ et $Ar^3$ représentent un groupe aryle qui comporte 6 atomes de carbone, lequel peut être substitué par jusqu'à trois radicaux $R^3$; les radicaux $Ar^2$ et $Ar^3$ peuvent également être liés l'un à l'autre par une liaison simple ou par un pont qui est sélectionné parmi $B(R^5)$, $C(R^5)_2$, $Si(R^5)_2$, C=O, $C=NR^5$, $C=C(R^5)_2$, 0, S, S=O, $SO_2$, $N(R^5)$, $P(R^5)$ et $P(=O)R^5$.

3. Composition comprenant au moins un composé selon la revendication 1 ou 2 et au moins un autre composé qui est sélectionné parmi le groupe qui est constitué par les émetteurs fluorescents, les émetteurs phosphorescents, les matériaux hôtes, les matériaux de matrice, les matériaux de transport d'électrons, les matériaux d'injection d'électrons, les matériaux conducteurs de trous, les matériaux d'injection de trous, les matériaux de blocage d'électrons et les matériaux de blocage de trous.

4. Formulation comprenant au moins un composé selon la revendication 1 ou 2 ou au moins une composition selon la revendication 3 et au moins un solvant.

5. Procédé pour la préparation d'un composé selon la revendication 1 ou 2 par réaction d'au moins un composé aryllithium avec au moins un halogénure de bore et/ou au moins un ester d'acide borinique.

6. Utilisation d'un composé selon la revendication 1 ou 2 dans un dispositif électronique en tant que matériau de blocage de trous, matériau d'injection d'électrons et/ou matériau de transport d'électrons.

7. Dispositif électronique contenant au moins un composé contenant du bore selon la revendication 1 ou 2 ou une composition selon la revendication 3, dans lequel le dispositif électronique est de préférence sélectionné parmi le groupe qui est constitué par les dispositifs électroluminescents organiques, les circuits intégrés organiques, les transistors à effet de champ organiques, les transistors à film mince organiques, les transistors à émission de lumière ou électroluminescents organiques, les cellules solaires organiques, les détecteurs optiques organiques, les photorécepteurs organiques, les dispositifs à extinction de champ organiques, les cellules électrochimiques à émission de lumière ou électroluminescentes ou les diodes laser organiques.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 9013148 A1
- WO 02052661 A1
- WO 02051850 A1
- WO 2002051850 A1
- EP 842208 A
- WO 2000022026 A
- EP 707020 A
- EP 894107 A
- WO 2006061181 A
- WO 9218552 A
- WO 2004070772 A
- WO 2004113468 A
- EP 1028136 A
- WO 2005014689 A
- WO 2004041901 A
- WO 2004113412 A
- WO 2005040302 A
- WO 2005104264 A
- WO 2007017066 A
- US 7294849 B
- WO 200070655 A
- WO 200141512 A
- WO 200202714 A
- WO 200215645 A
- EP 1191613 A
- EP 1191612 A
- EP 1191614 A
- WO 2005033244 A
- WO 2005019373 A
- US 20050258742 A
- WO 2005011013 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- WO 2009148015 A
- US 20090136779 A
- WO 2010050778 A
- WO 2011042107 A
- WO 2011088877 A
- WO 2010108579 A
- WO 2004058911 A
- WO 2004037887 A
- EP 1345948 B1


### In der Beschreibung aufgeführte Nicht-Patentliteratur


- **B. M. S. ARNOLD et al.** *Appl. Phys. Lett.,* 2008, vol. 92, 053301